(19) Europäisches Patentamt
European Patent Office
Office européen des brevets

(11) **EP 2 240 929 B1**

(12) **EUROPÄISCHE PATENTSCHRIFT**

(45) Veröffentlichungstag und Bekanntmachung des Hinweises auf die Patenterteilung:
**24.12.2014 Patentblatt 2014/52**

(51) Int Cl.:
*G10L 19/008* (2013.01) *H04S 3/00* (2006.01)

(21) Anmeldenummer: **09711228.8**

(22) Anmeldetag: **10.02.2009**

(86) Internationale Anmeldenummer:
**PCT/EP2009/000918**

(87) Internationale Veröffentlichungsnummer:
**WO 2009/100876 (20.08.2009 Gazette 2009/34)**

(54) **VORRICHTUNG UND VERFAHREN ZUM SYNCHRONISIEREN VON MEHRKANALERWEITERUNGSDATEN MIT EINEM AUDIOSIGNAL UND ZUM VERARBEITEN DES AUDIOSIGNALS**

DEVICE AND METHOD FOR SYNCHRONIZING MULTI-CHANNEL EXPANSION DATA WITH AN AUDIO SIGNAL AND FOR PROCESSING SAID AUDIO SIGNAL

DISPOSITIF ET PROCÉDÉ POUR SYNCHRONISER DES DONNÉES D'EXTENSION À PLUSIEURS CANAUX AVEC UN SIGNAL AUDIO ET POUR TRAITER LE SIGNAL AUDIO

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **14.02.2008 DE 102008009024**

(43) Veröffentlichungstag der Anmeldung:
**20.10.2010 Patentblatt 2010/42**

(73) Patentinhaber: **Fraunhofer-Gesellschaft zur Förderung der angewandten Forschung e.V.
80686 München (DE)**

(72) Erfinder:
• **SCHARRER, Sebastian
91217 Hersbruck (DE)**

• **FIESEL, Wolfgang
90596 Schwanstetten Süd (DE)**
• **PICKEL, Jörg
91224 Pommelsbrunn (DE)**
• **NEUSINGER, Matthias
91189 Rohr (DE)**

(74) Vertreter: **Zinkler, Franz et al
Schoppe, Zimmermann, Stöckeler & Zinkler
Patentanwälte
Postfach 246
82043 Pullach bei München (DE)**

(56) Entgegenhaltungen:
**WO-A-2005/011281 WO-A-2006/102991
DE-A1-102004 046 746**

**Beschreibung**

Die vorliegende Erfindung bezieht sich auf die Audio-Mehrkanaltechnik und insbesondere auf die Synchronisation von Mehrkanalerweiterungsdaten mit einem Audiosignal, um eine Mehrkanalrekonstruktion zu ermöglichen.

Derzeit in der Entwicklung befindliche Technologien ermöglichen eine immer effizientere Übertragung von Audiosignalen durch Datenreduktion, aber auch eine Steigerung des Hörgenusses durch Erweiterungen, wie beispielsweise durch den Einsatz von Mehrkanaltechnik.

Beispiele für eine solche Erweiterung der üblichen Übertragungstechniken sind unter dem Namen "Binaural Cue Coding" (BCC) sowie "Spatial Audio Coding" bekannt geworden. Hierzu wird beispielhaft auf J. Herre, C. Faller, S. Disch, C. Ertel, J. Hilpet, A. Hoelzer, K. Linzmeier, C. Spenger, P. Kroon: "Spatial Audio Coding: Next-Generation Efficient and Compatibel Coding Oberfläche Multi-Channel Audio", 117th AES Convention, San Francisco 2004, Preprint 6186, verwiesen.

Solche Verfahren trennen in einem sequentiell arbeitenden Übertragungssystem wie Rundfunk oder Internet das zu übertragende Audioprogramm in Audiobasisdaten beziehungsweise ein Audiosignal aus, das ein Mono- oder auch ein Stereodownmixaudiosignal sein kann, und in Erweiterungsdaten, die auch als Mehrkanalzusatzinformationen oder Mehrkanalerweiterungsdaten bezeichnet werden, auf. Die Mehrkanalerweiterungsdaten können zusammen mit dem Audiosignal, also kombiniert ausgestrahlt werden, oder die Mehrkanalerweiterungsdaten können auch separat von dem Audiosignal ausgestrahlt werden. Alternativ zur Ausstrahlung eines Rundfunkprogramms können die Mehrkanalerweiterungsdaten auch separat zu einer beim Benutzer zum Beispiel schon vorliegenden Version des Downmix-Kanals übertragen werden. In diesem Fall findet die Übertragung des Audiosignals beispielsweise in Form eines Internet-Downloads oder eines Kaufs einer Compactdisk oder DVD räumlich und zeitlich getrennt von der Übertragung der Mehrkanalerweiterungsdaten statt, welche beispielsweise von einem Mehrkanalerweiterungsdaten-Server geliefert werden können.

Prinzipiell hat die Trennung eines Mehrkanalaudiosignals in ein Audiosignal und Mehrkanalerweiterungsdaten folgende Vorteile. Ein "klassischer" Empfänger ist jederzeit unabhängig von Inhalt und Version der Mehrkanalzusatzinformationen in der Lage, die Audiobasisdaten, also das Audiosignal zu empfangen und wiederzugeben. Diese Eigenschaft wird als Rückwärtskompatibilität bezeichnet. Darüber hinaus kann ein Empfänger der neueren Generation die übertragenen Mehrkanalzusatzdaten auswerten und diese mit den Audiobasisdaten, also mit dem Audiosignal so kombinieren, dass dem Nutzer die vollständige Erweiterung, d. h. der Mehrkanalton, zur Verfügung gestellt werden kann.

Bei einem Beispielsanwendungsszenario im digitalen Rundfunk kann mit Hilfe dieser Mehrkanalerweiterungsdaten das bisher ausgestrahlte Stereoaudiosignal durch geringen zusätzlichen Übertragungsaufwand auf das Mehrkanalformat 5.1 erweitert werden. Das Mehrkanalformat 5.1 hat fünf Wiedergabekanäle, also einen linken Kanal L, einen rechten Kanal R, einen mittleren Kanal C, einen linken hinteren Kanal LS (left surround) und einen rechten hinteren Kanal RS (right sur-round). Hierzu erzeugt der Programmanbieter auf der Senderseite aus Mehrkanaltonquellen, wie sie z. B. auf einer DVD/Audio/Video zu finden sind, die Mehrkanalzusatzinformationen. Anschließend kann diese Mehrkanalzusatzinformation parallel zum wie bisher ausgestrahlten Audiostereosignal übertragen werden, welches nun einen Stereodownmix des Multikanalsignales enthält.

Ein Vorteil dieses Verfahrens ist dabei die Kompatibilität mit dem bisher bestehenden digitalen Rundfunkübertragungssystem. Ein klassischer Empfänger, der diese Zusatzinformation nicht auswerten kann, wird wie bisher das Zweikanaltonsignal ohne irgendwelche qualitativen Einschränkungen empfangen und wiedergeben können.

Ein Empfänger neuerer Bauart hingegen kann zusätzlich zum bisher empfangenen Stereotonsignal die Mehrkanalinformationen auswerten, dekodieren und das ursprüngliche 5.1 Mehrkanalsignal daraus rekonstruieren.

Um eine gleichzeitige Übertragung der Mehrkanalzusatzinformationen als Ergänzung zum bisher verwendeten Stereotonsignal zu ermöglichen, sind zwei Lösungen für die kompatible Ausstrahlung über ein digitales Rundfunksystem denkbar.

Die erste Lösung besteht darin, die Mehrkanalzusatzinformationen mit dem codierten Downmixaudiosignal so zu kombinieren, dass die in dem von einem Audiocodierer erzeugten Datenstrom als geeignete und kompatible Erweiterung angehängt werden können. In diesem Fall sieht der Empfänger nur einen (gültigen) Audiodatenstrom und kann daraus die Mehrkanaltonzusatzinformationen über einen entsprechend vorgeschalteten Datenverteiler wieder synchron zu dem dazugehörigen Audiodatenblock extrahieren, dekodieren und als 5.1-Mehrkanalton ausgeben.

Diese Lösung benötigt die Erweiterung der vorhandenen Infrastruktur/Datenwege, so dass sie statt wie bisher lediglich die Stereoaudiosignale, nun die aus Downmixsignalen und Erweiterung bestehenden Datensignale transportieren können. Dies ist zum Beispiel dann ohne Zusatzaufwand möglich beziehungsweise unproblematisch, wenn es sich um eine datenreduzierte Darstellung handelt, d. h. einen Bitstrom, welcher die Downmix-Signale überträgt. In diesen Bitstrom kann dann ein Feld für die Erweiterungsinformation eingefügt werden.

Eine zweite denkbare Lösung besteht darin, die Mehrkanaltonzusatzinformationen nicht an das verwendete Audiocodierungssystem zu koppeln. In diesem Fall werden die Mehrkanalerweiterungsdaten nicht in den eigentlichen Audiodatenstrom eingekoppelt. Die Übertragung erfolgt stattdessen über einen gesonderten, aber zeitlich nicht notwendigerweise synchronisierten Zusatzkanal, welcher z. B. ein paralleler digitaler Zusatzkanal sein kann. Eine solche Situation tritt beispielsweise dann auf, wenn die Downmixdaten, also das Audiosignal, in unreduzierter Form z. B. als PCM-Daten per AES/EBU-Datenformat, durch eine in Studios vorhandene übliche Audioverteilungsinfrastruktur geleitet werden. Diese Infrastrukturen sind darauf ausgerichtet, Audiosignale zwischen diversen Quellen digital zu verteilen ("Kreuzschienen") und/oder zu bearbeiten, beispielsweise mittels einer Klangregelung, einer Dynamikkompression, etc..

In der zweiten denkbaren Lösung, die vorstehend beschrieben worden ist, kann das Problem der zeitlichen Versetzung des Downmixaudiosignal und Mehrkanalzusatzinformationen im Empfänger auftreten, da beide Signale unterschiedliche, nicht synchronisierte Datenpfade durchlaufen. Ein zeitlicher Versatz zwischen Downmixsignal und Zusatzinformation führt jedoch zu einer Verschlechterung der Klangqualität des rekonstruierten Mehrkanalsignals, da dann auf Wiedergabeseite ein Audiosignal mit Mehrkanalerweiterungsdaten verarbeitet wird, die eigentlich nicht zu dem aktuellen Audiosignal gehören, sondern zu einem früheren oder späteren Abschnitt beziehungsweise Block des Audiosignals.

Da die Größenordnung der zeitlichen Verschiebung nicht mehr aus dem empfangenen Audiosignal und den Zusatzinformationen ermittelbar ist, ist eine zeitlich korrekte Rekonstruktion und Zuordnung des Mehrkanalsignals im Empfänger nicht gewährleistet, was zu den Qualitätseinbußen führen wird.

Ein weiteres Beispiel für diese Situation besteht dann, wenn ein bereits laufendes 2-kanaliges Übertragungssystem auf eine Multikanal-Übertragung erweitert werden soll, wenn z. B. an einen Empfänger für digitales Radio gedacht wird. Hie ist es oft der Fall, dass die Decodierung des Downmixsignals mittels eines in dem Empfänger bereits vorhandenen Audiodecodierers, also zum Beispiel eines Stereo-Audiodecodierers nach dem MPEG-4-Standard, geschieht. Die Verzögerungszeit dieses Audiodecodierers ist nicht immer bekannt beziehungsweise kann nicht immer mit Sicherheit vorausgesagt werden, und zwar aufgrund der systemimmanenten Datenkompression von Audiosignalen. Daher kann die Verzögerungszeit eines solchen Audio-Decodierers auch nicht zuverlässig ausgeglichen werden.

Im Extremfall kann das Audiosignal den Mehrkanal-Audiodecodierer sogar über eine Übertragungskette erreichen, die analoge Teile enthält. Hierbei wird an einem Punkt in der Übertragung eine Digital-/Analog-Umsetzung vorgenommen, welche nach einer weiteren Speicherung/Übertragung wieder von einer Analog-/Digital-Umsetzung gefolgt wird. Auch hier sind zunächst keinerlei Anhaltspunkte verfügbar, wie ein passender Verzögerungsausgleich des Downmixsignals relativ zu den Mehrkanalzusatzdaten durchgeführt werden kann. Wenn die Abtastfrequenz für die Analog-/Digital-Wandlung und die Digital-/Analog-Wandlung leicht voneinander abweichen, so entsteht sogar eine langsame zeitliche Drift der notwendigen Ausgleichsverzögerung entsprechend dem Verhältnis der beiden Abtastraten zueinander.

Das deutsche Patent DE 10 2004 046 746 B4 offenbart ein Verfahren und eine Vorrichtung zum Synchronisieren von Zusatzdaten und Basisdaten. Ein Benutzer stellt auf der Basis seiner Stereodaten einen Fingerabdruck zur Verfügung. Ein Erweiterungsdaten-Server identifiziert das Stereosignal auf der Basis des erhaltenen Fingerabdrucks und greift auf eine Datenbank zu, um die Erweiterungsdaten für dieses Stereosignal wieder zu gewinnen. Insbesondere identifiziert der Server ein ideales Stereosignal, das mit dem beim Benutzer vorhandenen Stereosignal korrespondiert und erzeugt zwei Testfingerabdrücke des zu den Erweiterungsdaten gehörigen idealen Audiosignals. Diese beiden Testfingerabdrücke werden dann zum Client geliefert, der daraus einen Stauchungs/Dehnungsfaktor und einen Referenzversatz ermittelt, wobei basierend auf dem Referenzversatz die Zusatzkanäle gedehnt/gestaucht und am Anfang und am Ende abgeschnitten werden. Hierauf kann eine Multikanaldatei unter Verwendung der Basisdaten und der Erweiterungsdaten erzeugt werden.

Die Aufgabe der vorliegenden Erfindung besteht darin, ein Synchronisationskonzept zu schaffen, das eine Mehrkanalrekonstruktion mit hoher Qualität erreicht, indem eine genaue Synchronisation von Mehrkanalerweiterungsdaten mit einem Audiosignal erreicht wird.

Diese Aufgabe wird durch eine Vorrichtung zum Synchronisieren gemäß Patentanspruch 1, ein Verfahren zum Synchronisieren gemäß Patentanspruch 13, eine Vorrichtung zum Verarbeiten eines Audiosignals gemäß Patentanspruch 14, ein Verfahren zum Verarbeiten des Audiosignals gemäß Patentanspruch 27 oder ein Computerprogramm gemäß Patentanspruch 28 gelöst.

Der vorliegenden Erfindung liegt die Erkenntnis zugrunde, dass eine genaue Synchronisation mittels einer blockbasierten Fingerabdrucktechnologie effizient und zuverlässig erreicht wird. Es hat sich herausgestellt, dass blockweise berechnete Fingerabdrücke ein gutes und effizientes Charakteristikum für ein Audiosignal darstellen. Um jedoch die Synchronisation auf eine Ebene zu bringen, die kleiner als eine Blockdauer ist, wird das Audiosignal mit einer Blockeinteilungsinformation versehen, die bei einer Synchronisierung detektiert und zur Fingerabdruckberechnung einsetzbar ist.

Das Audiosignal umfasst somit eine Blockeinteilungsinformation, die zum Zeitpunkt des Synchronisierens verwendet werden kann. Damit wird sicher gestellt, dass die Fingerabdrücke, die beim Synchronisieren von dem Audiosignal abgeleitet werden, auf der selben Blockeinteilung beziehungsweise Blockrasterung basieren wie Fingerabdrücke des Audiosignals, die den Mehrkanalerweiterungsdaten zugeordnet sind. Insbesondere umfassen die Mehrkanalerweiterungsdaten eine Folge von Referenz-Audiosignal-Fingerabdruckinformationen. Diese Referenz-Audiosignal-Fingerabdruckinformationen liefern eine im Mehrkanalerweiterungsstrom enthaltene Zuordnung zwischen einem Block von Mehrkanalerweiterungsdaten und dem Abschnitt beziehungsweise Block des Audiosignals, zu dem die Mehrkanalerweiterungsdaten gehören.

Zur Synchronisation werden aus den Mehrkanalerweiterungsdaten die Referenz-Audiosignal-Fingerabdrücke extrahiert und mit den vom Synchronisierer berechneten Test-Audio-Signal-Fingerabdrücken korreliert. Der Korrelator muss lediglich eine Block-Korrelation erreichen, da aufgrund der Verwendung der Blockeinteilungsinformation die Blockrasterung, die den beiden Folgen von Fingerabdrücken zugrunde liegt, bereits identisch ist.

Damit kann trotz der Tatsache, dass lediglich Fingerabdruckfolgen auf Blockniveau korreliert werden müssen, eine nahezu Sample-genaue Synchronisation der Mehrkanalerweiterungsdaten mit dem Audiosignal erreicht werden.

Die Blockeinteilungsinformation, die in dem Audiosignal enthalten ist, kann als explizite Seiteninformation z. B. in einem Header des Audiosignals angegeben sein. Alternativ kann auch dann, wenn eine digitale, jedoch unkomprimierte Übertragung vorhanden ist, diese Blockeinteilungsinformation auch in einem Sample enthalten sein, der z. B. das erste Sample eines Blocks war, der gebildet wurde, um die Referenzaudiosignal-Fingerabdrücke zu berechnen, die in den Mehrkanalerweiterungsdaten enthalten sind. Alternativ oder zusätzlich kann die Blockeinteilungsinformation auch direkt in das Audiosignal selbst, z. B. mittels einer Wasserzeichen-Einbettung, eingebracht werden. Hierfür eignet sich besonders eine Pseudorausch-Sequenz, es können jedoch auch andere Arten und Weisen von Wasserzeicheneinbettungen verwendet werden, um eine Blockeinteilungsinformation in das Audiosignal einzubringen. Vorteil dieser Wasserzeichenimplementierung ist, dass auch beliebige Analog/Digital- oder Digital/Analog-Wandlungen unkritisch sind. Ferner existieren auch gegenüber der Datenkompression robuste Wasserzeichen, die sogar eine Kompression/Dekompression beziehungsweise sogar Tandem-Codierungsstufen überstehen werden und als zuverlässige Blockeinteilungsinformation zu Synchronisationszwecken eingesetzt werden können.

Darüber hinaus wird es bevorzugt, in den Datenstrom der Mehrkanalerweiterungsdaten die Referenz-Audiosignal-Fingerabdruckinformationen direkt, blockweise einzubetten. Bei diesem Ausführungsbeispiel wird das Auffinden eines geeigneten Zeitoffsets unter Benutzung eines Fingerabdrucks mit einem nicht getrennt von den Mehrkanalerweiterungsdaten abgelegten Daten-Fingerabdruck erreicht. Stattdessen wird zu jedem Block der Mehrkanalerweiterungsdaten in diesem Block selbst der Fingerabdruck eingebettet. Alternativ können die Referenz-Audiosignal-Fingerabdruckinformationen, den Mehrkanal-Erweiterungsdaten zugeordnet sein, jedoch aus einer separaten Quelle stammen.

Bevorzugte Ausführungsbeispiele der vorliegenden Erfindung werden nachfolgend bezugnehmend auf die beiliegenden Zeichnungen detailliert erläutert. Es zeigen:

Fig. 1 ein Blockschaltbild einer Vorrichtung zum Verarbeiten des Audiosignals, um ein synchronisierbares Ausgangssignal mit Mehrkanalerweiterungsdaten zu schaffen, gemäß einem Ausführungsbeispiel der Erfindung;

Fig. 2 eine detaillierte Darstellung des Fingerabdruck-Berechners von Fig. 1; und

Fig. 3a ein Blockschaltbild einer Vorrichtung zum Synchronisieren gemäß einem Ausführungsbeispiel der Erfindung;

Fig. 3b eine detailliertere Darstellung des Ausgleichers von Fig. 3a;

Fig. 4a eine schematische Darstellung eines Audiosignals mit einer Blockeinteilungsinformation;

Fig. 4b eine schematische Darstellung von Mehrkanalerweiterungsdaten mit blockweise eingebetteten Fingerabdrücken;

Fig. 5 eine schematische Darstellung eines Wasserzeichen-Einbetters zum Erzeugen eines Audiosignals mit einem Wasserzeichen;

Fig. 6 eine schematische Darstellung eines Wasserzeichen-Extraktors zur Extraktion der Blockeinteilungsinformation;

Fig. 7 eine schematische Darstellung eines Ergebnisdiagramms, wie es nach einer Korrelation über z. B. 30 Blöcke der Test-Blockeinteilung erscheint;

Fig. 8 ein Ablaufdiagramm zur Veranschaulichung verschiedener Fingerabdruck-Berechnungsmöglichkeiten;

Fig. 9 ein Mehrkanal-Codierer-Szenario mit einer erfindungsgemäßen Vorrichtung zum Verarbeiten;

Fig. 10 ein Mehrkanal-Decodierer-Szenario mit einem erfindungsgemäßen Synchronisierer;

Fig. 11a    eine detailliertere Darstellung des Mehrkanalerweiterungsdatenberechners von Fig. 9; und

Fig. 11b    eine detailliertere Darstellung eines Blocks mit Mehrkanalerweiterungsdaten, wie er durch die in Fig. 11a gezeigte Anordnung erzeugbar ist.

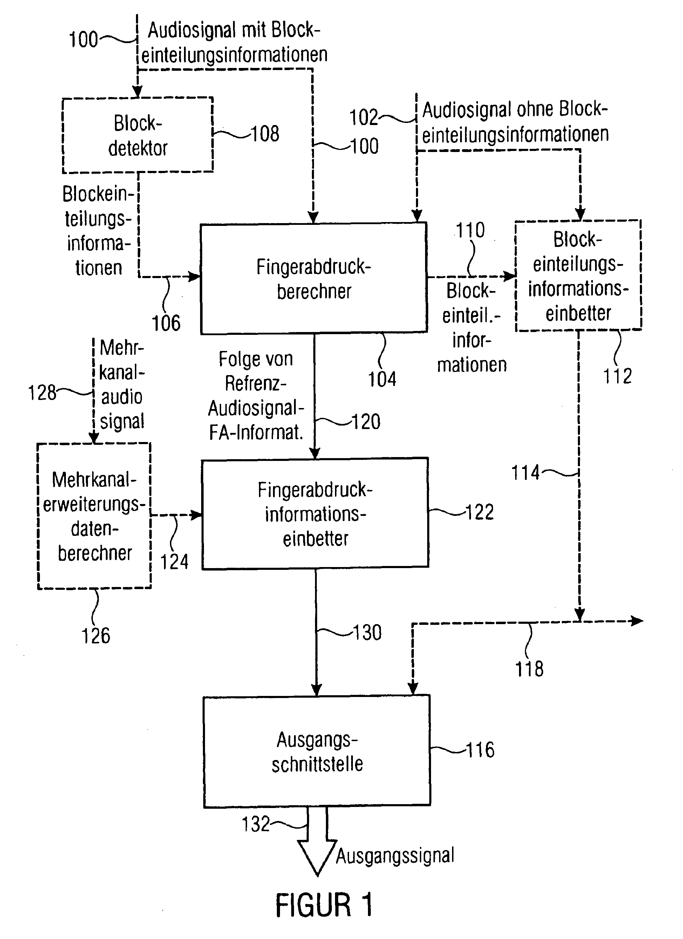

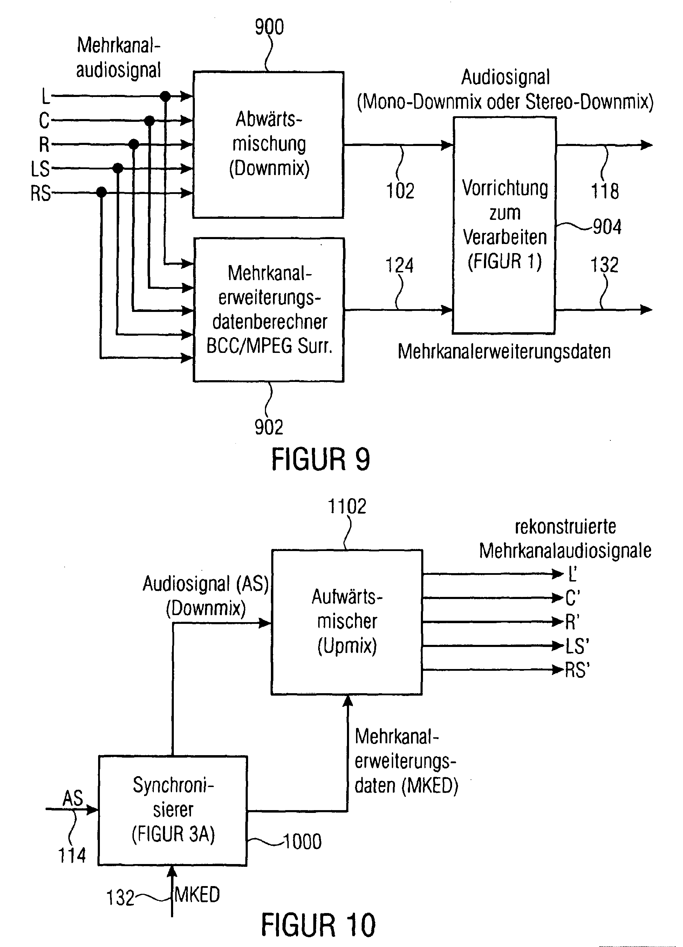

Fig. 1 zeigt ein schematisches Diagramm einer Vorrichtung zum Verarbeiten eines Audiosignals, wobei das Audiosignal bei 100 mit einer Blockeinteilungsinformation gezeigt ist, während das Audiosignal 102 bei keine Blockeinteilungsinformationen umfassen kann. Die Vorrichtung zum Verarbeiten eines Audiosignals von Fig. 1, die in einem Encodierer-Szenario, auf das noch bezugnehmend auf Fig. 9 eingegangen wird, einsetzbar ist, umfasst einen Fingerabdruck-Berechner 104 zum Berechnen eines Fingerabdrucks pro Block des Audiosignals für eine Mehrzahl von aufeinander folgenden Blöcken, um eine Folge von Referenz-Audiosignal-Fingerabdruckinformationen zu erhalten. Der Fingerabdruck-Berechner ist ausgebildet, um eine vorbestimmte Blockeinteilungsinformation 106 zu verwenden. Die vorbestimmte Blockeinteilungsinformation 106 kann beispielsweise durch einen Blockdetektor 108 aus dem Audiosignal 100 mit Blockeinteilungsinformationen detektiert werden. Sobald die Blockeinteilungsinformation 106 detektiert ist, ist der Fingerabdruck-Berechner 104 in der Lage, aus dem Audiosignal 100 die Folge von Referenz-Fingerabdrücken zu berechnen.

Erhält der Fingerabdruck-Berechner 104 jedoch ein Audiosignal 102 ohne Blockeinteilungsinformationen, so wählt der Fingerabdruck-Berechner 104 irgendeine Blockeinteilung und führt eine allererst Blockeinteilung durch. Diese Blockeinteilung wird über eine Blockeinteilungsinformation 110 einem Blockeinteilungsinformationseinbetter 112 signalisiert, der ausgebildet ist, um in das Audiosignal 102 ohne Blockeinteilungsinformationen die Blockeinteilungsinformationen 110 einzubetten. Ausgangsseitig liefert der Blockeinteilungsinformationseinbetter, somit ein Audiosignal 114 mit Blockeinteilungsinformationen, wobei dieses Audiosignal über eine Ausgangsschnittstelle 116 ausgegeben werden kann oder unabhängig von der Ausgabe über die Ausgangsschnittstelle 116 separat gespeichert oder über einen anderen Weg ausgegeben werden kann, wie es bei 118 schematisch dargestellt ist.

Der Fingerabdruck-Berechner 104 ist ausgebildet, um eine Folge von Referenz-Audiosignal-Fingerabdruck-Informationen 120 zu berechnen. Diese Folge von Referenz-Audiosignal-Fingerabdruck-Information wird einem Fingerabdruckinformationseinbetter 122 zugeführt. Der FingerabdruckInformationseinbetter bettet die Referenz-Audiosignal-Fingerabdruck-Informationen 120 in Mehrkanalerweiterungsdaten 124 ein, die separat bereitgestellt werden können, oder die auch direkt von einem Mehrkanalerweiterungsdatenberechner 126 berechnet werden können, der eingangsseitig ein Mehrkanalaudiosignal 128 empfängt. Ausgangsseitig liefert der Fingerabdruckinformationseinbetter 122 somit Mehrkanalerweiterungsdaten mit zugeordneten Referenz-Audiosignal-Fingerabdruckinformationen, wobei diese Daten mit 130 bezeichnet sind. Der Fingerabdruckinformationseinbetter 122 ist ausgebildet, um die Referenz-Audiosignal-Fingerabdruckinformationen direkt gewissermaßen auf Blockebene in die Mehrkanalerweiterungsdaten einzubetten. Alternativ oder zusätzlich wird der Fingerabdruckinformationseinbetter 122 auch die Folge von Referenz-Audiosignal-Fingerabdruckinformationen anhand der Zuordnung zu einem Block von Multikanalerweiterungsdaten speichern beziehungsweise bereitstellen, wobei dieser Block der Multikanalerweiterungsdaten zusammen mit einem Block des Audiosignals eine möglichst gute Approximation eines Multikanalaudiosignals beziehungsweise des Mehrkanalaudiosignals 128 darstellt.

Die Ausgangsschnittstelle 116 ist ausgebildet, um ein Ausgangssignal 132 auszugeben, das die Folge von Referenz-Audiosignal-Fingerabdruck-Informationen und die Mehrkanalerweiterungsdaten in eindeutiger Zuordnung, wie beispielsweise innerhalb eines eingebetteten Datenstroms, umfasst. Alternativ kann das Ausgangssignal auch eine Folge von Blöcken von Mehrkanalerweiterungsdaten ohne Referenz-Audiosignal-Fingerabdruck-Informationen sein. Die Fingerabdruckinformationen werden dann in einer eigenen Folge von Fingerabdruckinformationen geliefert, wobei beispielsweise jeder Fingerabdruck über eine fortlaufende Blocknummer mit einem Block von Mehrkanalerweiterungsdaten "verbunden" ist. Alternative Zuordnungen von Fingerabdruckdaten zu Blöcken, wie beispielsweise über eine implizite Signalisierung einer Reihenfolge etc. sind ebenfalls verwendbar.

Das Ausgangssignal 132 kann ferner auch ein Audiosignal mit Blockeinteilungsinformationen umfassen. Bei speziellen Anwendungsfällen, wie beispielsweise beim Rundfunk, wird das Audiosignal mit Blockeinteilungsinformationen jedoch einen separaten Weg 118 gehen.

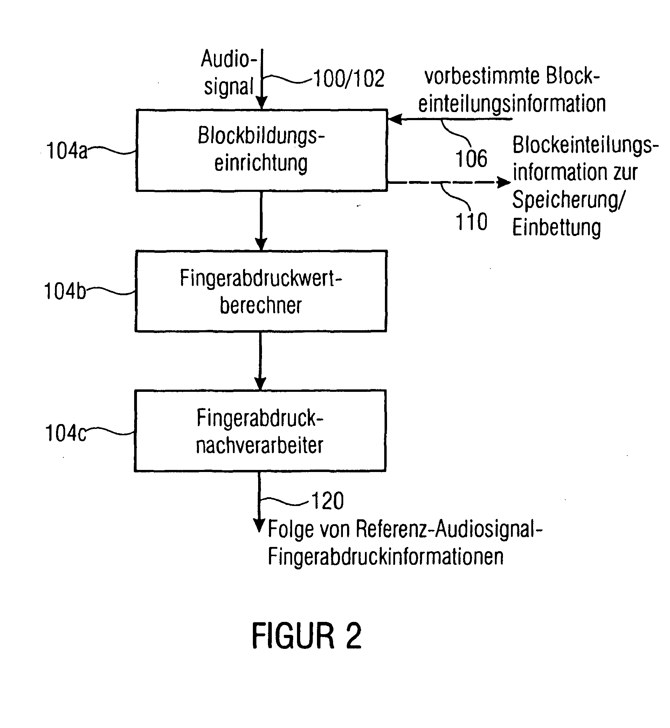

Fig. 2 zeigt eine detailliertere Darstellung des Fingerabdruck-Berechners 104. Bei dem in Fig. 2 gezeigten Ausführungsbeispiel umfasst der Fingerabdruck-Berechner 104 eine Blockbildungseinrichtung 104a, einen nachgeschalteten Fingerabdruckwert-Berechner 104b und einen Fingerabdrucknachverarbeiter 104c, um eine Folge von Referenz-Audiosignal-Fingerabdruck-Informationen 120 zu liefern. Die Blockbildungseinrichtung 104a ist ausgebildet, um dann, wenn sie die gewissermaßen erste Blockbildung durchführt, die Blockeinteilungsinformationen zur Speicherung/Einbettung 110 zu liefern. Hat das Audiosignal jedoch bereits eine Blockeinteilungsinformation, so wird die Blockbildungseinrichtung 104a steuerbar sein, um abhängig von der vorbestimmten Blockeinteilungsinformation 106 eine Blockbildung durchzuführen.

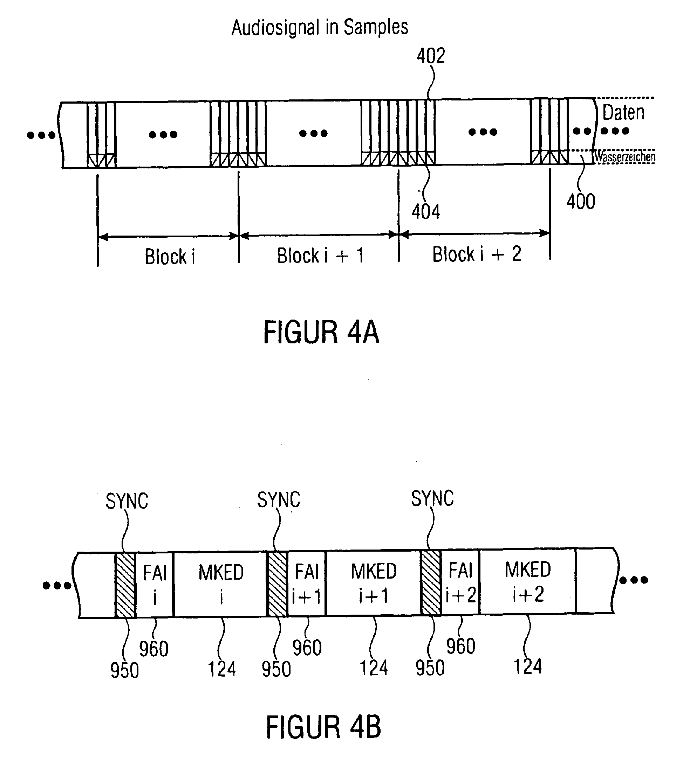

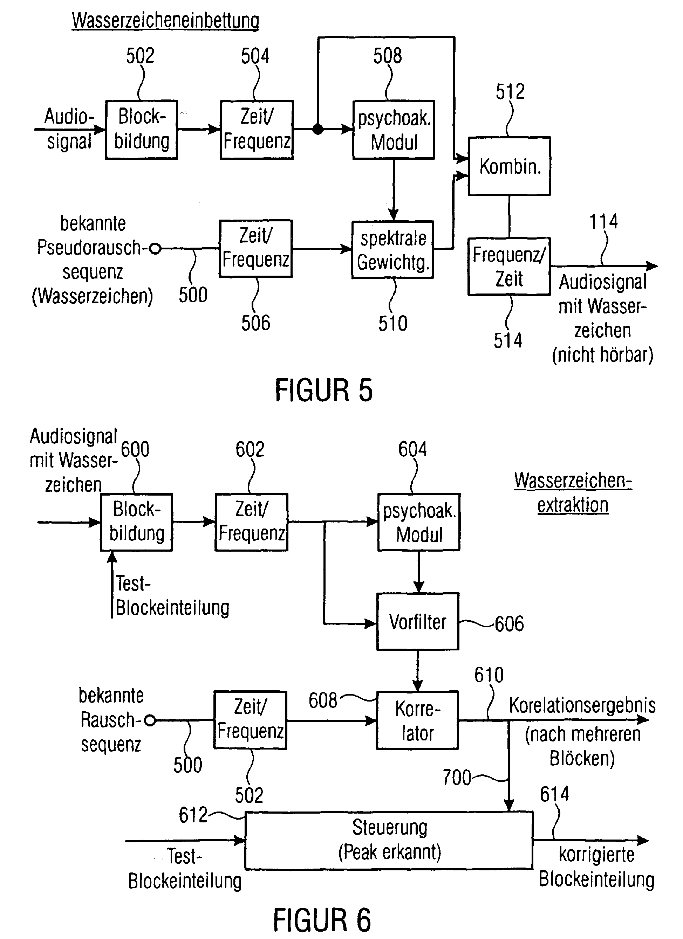

Bei einem Ausführungsbeispiel der vorliegenden Erfindung ist das Audiosignal mit einem Wasserzeichen versehen, wie es in Fig. 4a gezeigt ist. Insbesondere zeigt Fig. 4a ein Audiosignal mit einer Folge von Samples, wobei eine Blockeinteilung in Blöcke i, i+1, i+2 schematisch angedeutet ist. Allerdings umfasst das Audiosignal selbst bei dem in Fig. 4a gezeigten Ausführungsbeispiel keine solche explizite Blockeinteilung. Anstatt dessen ist in dem Audiosignal ein Wasserzeichen 400 derart eingebettet, dass jedes Audiosample einen Wasserzeichenanteil umfasst. Dieser Wasserzeichenanteil ist schematisch für ein Sample 402 bei 404 angedeutet. Insbesondere ist das Wasserzeichen 400 so eingebettet, dass anhand des Wasserzeichens die Blockstruktur detektierbar ist. Zu diesem Zweck ist das Wasserzeichen zum Beispiel eine bekannte periodische Pseudorauschsequenz, wie es in Fig. 5 bei 500 gezeigt ist. Diese bekannte Pseudorauschsequenz hat eine Periodendauer, die gleich der Blocklänge ist oder die größer als eine Blocklänge ist, wobei jedoch eine Periodendauer gleich der Blocklänge oder in der Größenordnung der Blocklänge bevorzugt wird.

Zur Wasserzeicheneinbettung wird, wie es in Fig. 5 gezeigt ist, zunächst eine Blockbildung 502 des Audiosignals vorgenommen. Dann wird ein Block des Audiosignals mittels einer Zeit-/Frequenzumsetzung 504 in den Frequenzbereich umgesetzt. Analog hierzu wird auch die bekannte Pseudorauschsequenz 500 über eine Zeit-/Frequenzumsetzung 506 in den Frequenzbereich transformiert. Hierauf berechnet ein psychoakustisches Modul 508 die psychoakustische Maskierungsschwelle des Audiosignalblocks, wobei, wie es in der Psychoakustik bekannt ist, ein Signal in einem Band dann im Audiosignal maskiert wird, also unhörbar ist, wenn die Energie des Signals in dem Band unterhalb des Werts der Maskierungsschwelle für dieses Band ist. Aufgrund dieser Information wird eine spektrale Gewichtung 510 zur spektralen Darstellung der Pseudorauschsequenz vorgenommen. Die spektralgewichtete Pseudorauschsequenz hat dann, vor einem Kombinierer 512, ein Spektrum, das einen Verlauf hat, der der psychoakustischen Maskierungsschwelle entspricht. Dieses Signal wird dann spektralwertweise mit dem Spektrum des Audiosignals in dem Kombinierer 512 kombiniert. Am Ausgang des Kombinierers 512 existiert somit ein Audiosignalblock mit eingebrachtem Wasserzeichen, wobei das Wasserzeichen jedoch durch das Audiosignal maskiert wird. Durch einen Frequenz-/Zeit-Umsetzer 514 wird der Block des Audiosignals in den Zeitbereich zurücktransformiert und es existiert das in Fig. 4a gezeigte Audiosignal, das nun jedoch ein Wasserzeichen hat, das eine Blockeinteilungsinformation dargestellt.

Es sei darauf hingewiesen, dass viele verschiedene Wasserzeicheneinbettungsstrategien existieren. So kann die spektrale Gewichtung 510 beispielsweise durch eine duale Operation im Zeitbereich vorgenommen werden, so dass eine Zeit-/Frequenzumsetzung 506 nicht nötig ist.

Des weiteren könnte das spektralgewichtete Wasserzeichen auch vor seiner Kombination mit dem Audiosignal in den Zeitbereich transformiert werden, so dass die Kombination 512 im Zeitbereich stattfinden würde, wobei in diesem Fall eine Zeit-/Frequenzumsetzung 504 nicht unbedingt nötig sein würde, sofern die Maskierungsschwelle ohne Transformation berechnet werden kann. Selbstverständlich kann auch eine unabhängig vom Audiosignal beziehungsweise von einer Transformationslänge des Audiosignals verwendete Berechnung der Maskierungsschwelle vorgenommen werden.

Vorzugsweise ist die Länge der bekannten Pseudorauschsequenz gleich der Länge eines Blocks. Dann funktioniert eine Korrelation zur Wasserzeichenextraktion besonders effizient und übersichtlich. Allerdings können auch längere Pseudorauschsequenzen verwendet werden, so lange eine Periodendauer der Pseudorauschsequenz gleich oder größer als die Blocklänge ist. Ferner kann auch ein Wasserzeichen verwendet werden, das kein weißes Spektrum hat, sondern das beispielsweise derart gestaltet ist, dass es lediglich spektrale Anteile in bestimmten Frequenzbändern hat, wie beispielsweise dem unteren Spektralband oder einem mittleren Spektralband. Hierdurch kann gesteuert werden, dass das Wasserzeichen nicht z. B. nur in die oberen Bänder eingebracht wird, die z. B. durch eine "Spectral Band Replication"-Technik, wie sie vom MPEG-4-Standard bekannt ist, bei einer Datenraten sparenden Übertragung eliminiert beziehungsweise parametrisiert werden.

Alternativ zur Verwendung eines Wasserzeichens kann auch eine Blockeinteilung vorgenommen werden, wenn z. B. ein digitaler Kanal existiert, bei dem jeder Block des Audiosignals von Fig. 4 dahingehend markiert werden kann, dass z. B. der erste Sample-Wert eines Blocks eine Flag erhält. Alternativ kann auch z. B. in einem Header eines Audiosignals eine Blockeinteilung signalisiert werden, die zur Berechnung des Fingerabdrucks verwendet wird, und die auch zur Berechnung der Mehrkanalerweiterungsdaten aus den ursprünglichen Mehrkanalaudiokanälen verwendet worden ist.

Um das Szenario der Berechnung der Mehrkanalerweiterungsdaten zu veranschaulichen, wird nachfolgend auf Fig. 9 Bezug genommen. Fig. 9 zeigt ein Encodierer-seitiges Szenario, wie es zum Reduzieren der Datenrate von Multikanal-Audiosignalen verwendet wird. Beispielhaft ist ein 5.1-Szenario gezeigt, wobei jedoch auch ein 7.1-, 3.0- oder ein alternatives Szenario eingesetzt werden kann. Auch für das Spatial-Audio-Object-Coding, das ebenfalls bekannt ist, und bei dem Audio-Objekte statt Audiokanäle codiert werden, bei dem die Multikanalerweiterungsdaten somit eigentlich Daten sind, mit denen Objekte rekonstruierbar sind, wird eine prinzipiell zweigliedrige Struktur verwendet, die in Fig. 9 angedeutet ist. Das Mehrkanalaudiosignal mit den mehreren Audiokanälen beziehungsweise Audioobjekten wird einem Abwärtsmischer 900 zugeführt, der ein Downmix-Audiosignal liefert, wobei das Audiosignal zum Beispiel ein Mono-Downmix oder ein Stereo-Downmix ist. Ferner wird eine Mehrkanalerweiterungsdatenberechnung in einem entsprechenden Mehrkanalerweiterungsdatenberechner 902 vorgenommen. Dort werden die Mehrkanalerweiterungsdaten berechnet, z. B. gemäß der BCC-Technik oder gemäß dem Standard, der unter dem Namen MPEG-Surround bekannt ist. Auch eine Erweiterungsdatenberechnung für Audioobjekte, die auch als Mehrkanalerweiterungsdaten bezeichnet werden, kann in dem Audiosignal 102 stattfinden. Die in Fig. 1 gezeigte Vorrichtung zum Verarbeiten des Audiosignals ist diesen bekannten beiden Blöcken 900, 902 nachgeschaltet, wobei die in Fig. 9 gezeigte Vorrichtung 904 zum Verarbeiten gemäß Fig. 1 z. B. ein Audiosignal 102 ohne Blockeinteilungsinformation als Mono-Downmix oder Stereo-Downmix erhält und ferner die Mehrkanalerweiterungsdaten über die Leitung 124 erhält. Der Mehrkanalerweiterungsdatenberechner 126 von Fig. 1 wird somit dem Mehrkanalerweiterungsdatenberechner 902 von Fig. 9 entsprechen. Ausgangsseitig liefert die Vorrichtung 904 zum Verarbeiten z. B. ein Audiosignal 118 mit eingebetteter Blockeinteilungsinformation sowie einen Datenstrom mit Mehrkanalerweiterungsdaten samt zugeordneten oder eingebetteten Referenz-Audiosignal-Fingerabdruck-Informationen, wie es in Fig. 1 bei 132 dargestellt ist.

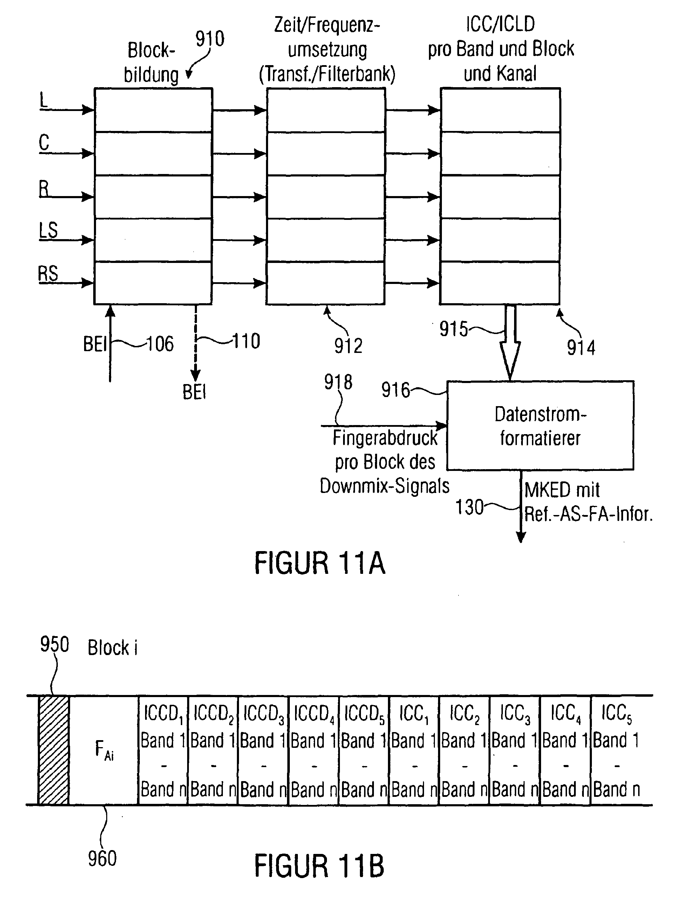

Fig. 11a zeigt eine detailliertere Darstellung des Mehrkanalerweiterungsdatenberechners 902. Insbesondere wird zunächst eine Blockbildung in jeweiligen Blockbildungseinrichtungen 910 vorgenommen, um für den ursprünglichen Kanal des Mehrkanalaudiosignals einen Block zu erhalten. Hierauf wird pro Block eine Zeit-/Frequenzumsetzung in einem Zeit/Frequenzumsetzer 912 vorgenommen. Der Zeit/Frequenzumsetzer kann eine Filterbank zur Durchführung einer Subbandfilterung, eine allgemeine Transformation oder insbesondere eine Transformation in Form einer FFT sein. Alternative Transformationen sind auch als MDCT, etc. bekannt. Hierauf wird im Mehrkanalerweiterungsdatenberechner pro Band, Block und beispielsweise auch pro Kanal ein eigener Korrelationsparameter zwischen dem Kanal und einem Referenzkanal, der mit ICC bezeichnet ist, berechnet. Ferner wird auch pro Band und Block und Kanal ein eigener Energieparameter ICLD berechnet, wobei dies in einem Parameterberechner 914 vorgenommen wird. Es sei darauf hingewiesen, dass die Blockbildungseinrichtung 910 Blockeinteilungsinformationen 106 verwendet, wenn bereits solche Blockeinteilungsinformationen existieren. Alternativ kann die Blockbildungseinrichtung 910 auch Blockeinteilungsinformationen selber festlegen, wenn die erste Blockeinteilung vorgenommen wird, und dann ausgeben und damit z. B. den Fingerabdruck-Berechner von Fig. 1 zu steuern. In Analogie zur Bezeichnung in Fig. 1 wird daher die ausgegebene Blockeinteilungsinformation ebenfalls mit 110 bezeichnet. Generell wird sichergestellt, dass die Blockbildung zur Berechnung der Mehrkanalerweiterungsdaten abgestimmt auf die Blockbildung zur Berechnung der Fingerabdrücke von Fig. 1 vorgenommen wird. Damit wird sichergestellt, dass eine Sample-genaue Synchronisation von Mehrkanalerweiterungsdaten zu dem Audiosignal erreichbar ist.

Die vom Parameterberechner 914 berechneten Parameterdaten werden einem Datenstromformatierer 916 zugeführt, der gleich dem Fingerabdruckinformationseinbetter 122 von Fig. 1 ausgebildet sein kann. Der Datenstromformatierer 916 empfängt ferner einen Fingerabdruck pro Block des Downmix-Signals, wie es bei 918 angegeben ist. Der Datenstromformatierer erzeugt dann mit dem Fingerabdruck und den empfangenen Parameterdaten 915 Mehrkanalerweiterungsdaten 130 mit eingebetteten Fingerabdruckinformationen, von denen ein Block schematisch in Fig. 11b dargestellt ist. Insbesondere sind die Fingerabdruckinformationen für diesen Block nach einem optional vorhandenen Synchronisationswort 950 bei 960 eingetragen. Dann, im Anschluss an die Fingerabdruckinformation 960, folgen die Parameter 915, die der Parameterberechner 940 berechnet hat, nämlich z. B. in der in Fig. 11b gezeigten Reihenfolge, bei der zunächst die ICLD-Parameter pro Kanal und Band auftreten, denen dann die ICC-Parameter pro Kanal und Band folgen. Insbesondere ist der Kanal durch den Index von "ICLD" signalisiert, wobei ein Index "1" zum Beispiel für den linken Kanal steht, ein Indes "2" für den mittleren Kanal steht, ein Index "3" für den rechten Kanal steht, ein Index "4" für den linken hinteren Kanal (LS) steht und ein Index "5" für den rechten hinteren Kanal (RS) steht.

Daraus ergibt sich dann allgemein gesagt ein Datenstrom mit Mehrkanalerweiterungsdaten, wie er in Fig. 4b dargestellt ist, wobei immer den Mehrkanalerweiterungsdaten 124 für einen Block der Fingerabdruck des Audiosignals, also des Stereo-Downmix-Signals oder des Mono-Downmix-Signals beziehungsweise allgemein des Downmix-Signals vorangestellt ist. In einer Implementierung können die Fingerabdruckinformationen für einen Block auch in Übertragungsrichtung nach den Multikanalerweiterungsdaten oder irgendwo zwischen den Multikanalerweiterungsdaten eingefügt werden. Alternativ können die Fingerabdruckinformationen auch in einem separaten Datenstrom übertragen werden beziehungsweise in einer separaten Tabelle, die z. B. über einen expliziten Blockidentifikator mit dem Multikanalerweiterungsdaten in Zuordnung steht oder bei der die Zuordnung implizit gegeben ist, nämlich durch die Reihenfolge der Fingerabdrücke zu der Reihenfolge der Multikanalerweiterungsdaten für die einzelnen Blöcke. Andere Zuordnungen ohne explizite Einbettung sind ebenfalls verwendbar.

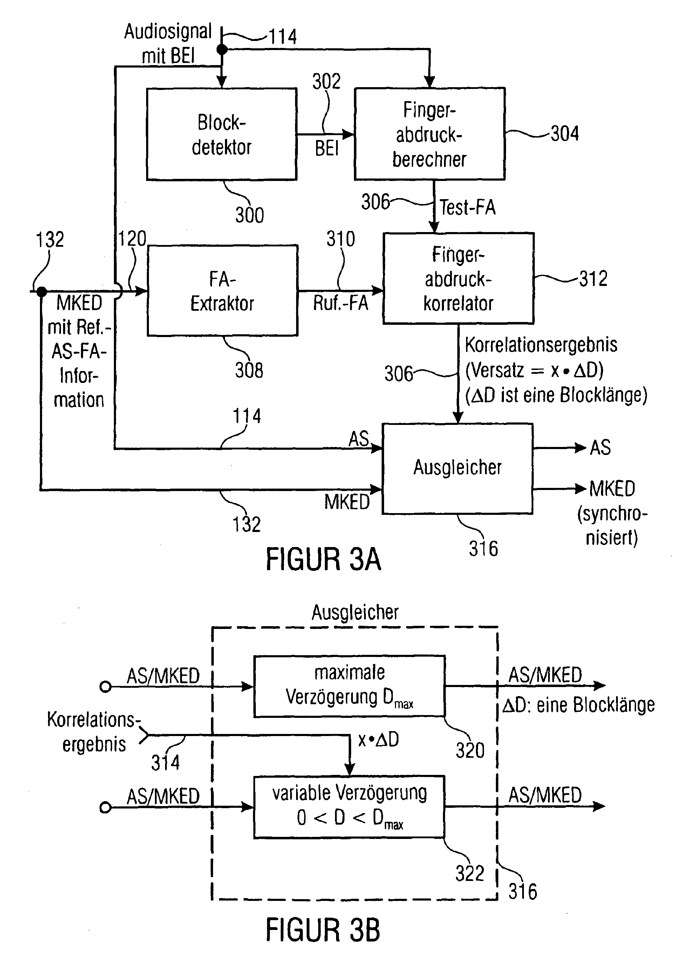

Fig. 3a zeigt eine Vorrichtung zum Synchronisieren von Mehrkanalerweiterungsdaten mit einem Audiosignal 114. Insbesondere umfasst das Audiosignal 114 Blockeinteilungsinformationen, wie es anhand von Fig. 1 dargestellt worden ist. Darüber hinaus sind den Mehrkanalerweiterungsdaten Referenz-Audiosignal-Fingerabdruck-Informationen zugeordnet.

Das Audiosignal mit den Blockeinteilungsinformationen wird einem Blockdetektor 300 zugeführt, der ausgebildet ist, um die Blockeinteilungsinformationen in dem Audiosignal zu detektieren, und um die detektierten Blockeinteilungsinformationen 302 einem Fingerabdruck-Berechner 304 zuzuführen. Der Fingerabdruck-Berechner 304 erhält ferner das Audiosignal, wobei hier nur mehr ein Audiosignal ohne Blockeinteilungsinformationen ausreichend wäre, wobei jedoch der Fingerabdruck-Berechner auch ausgebildet sein kann, um das Audiosignal mit Blockeinteilungsinformationen zu Fingerabdruckberechnung zu verwenden.

Der Fingerabdruck-Berechner 304 berechnet nunmehr einen Fingerabdruck pro Block des Audiosignals für eine Mehrzahl von aufeinander folgenden Blöcken, um eine Folge von Test-Audiosignal-Fingerabdrücken 306 zu erhalten. Insbesondere ist der Fingerabdruck-Berechner 304 ausgebildet, um die Blockeinteilungsinformationen 302 zu verwenden, um die Folge von Test-Audiosignal-Fingerabdrücken 306 zu berechnen.

Die erfindungsgemäße Synchronisationsvorrichtung beziehungsweise das erfindungsgemäße Synchronisationsverfahren basiert ferner auf einem Fingerabdruck-Extraktor 308 zum Extrahieren einer Folge von Referenz-Audiosignal-Fingerabdrücken 310 aus den Referenz-Audiosignal-Fingerabdruck-Informationen 120, wie sie dem Fingerabdruck-Extraktor 308 zugeführt werden.

Sowohl die Folge von Test-Fingerabdrücken 306 als auch die Folge von Referenz-Fingerabdrücken 308 werden einem Fingerabdruckkorrelator 312 zugeführt, der ausgebildet ist, um die beiden Folgen zu korrelieren. Abhängig von einem Korrelationsergebnis 314, bei dem ein Versatzwert erhalten wird, welcher ein ganzzahliges (x) der Blocklänge (ΔD) ist, wird ein Ausgleicher 316 gesteuert, um einen zeitlichen Versatz zwischen den Mehrkanalerweiterungsdaten 132 und dem Audiosignal 114 zu reduzieren oder im besten Fall zu eliminieren. Am Ausgang des Ausgleichers 316 werden somit sowohl das Audiosignal als auch die Mehrkanalerweiterungsdaten in synchronisierter Form ausgegeben, um einer Multikanalrekonstruktion zugeführt zu werden, wie sie bezugnehmend auf Fig. 10 erläutert wird.

In Fig. 10 ist der in Fig. 3a gezeigte Synchronisierer bei 1000 gezeigt. Der Synchronisierer 1000 enthält, wie es bezugnehmend auf Fig. 3a dargestellt worden ist, das Audiosignal 114 und die Mehrkanalerweiterungsdaten in nicht synchronisierter Form und liefert ausgangsseitig das Audiosignal und die Mehrkanalerweiterungsdaten nunmehr in synchronisierter Form einem Aufwärtsmischer 1102. Der Aufwärtsmischer 1102, der auch als "Upmix"-Block bezeichnet wird, kann nunmehr aufgrund des Audiosignals und der dazu synchronisierten Mehrkanalerweiterungsdaten rekonstruierte Mehrkanalaudiosignale L', C', R', LS' und RS' berechnen. Diese rekonstruierten Mehrkanalaudiosignale stellen eine Approximation an die ursprünglichen Mehrkanalaudiosignale, wie sie am Eingang des Blocks 900 in Fig. 9 dargestellt worden sind, dar. Alternativ stellen die rekonstruierten Mehrkanalaudiosignale am Ausgang des Blocks 1102 in Fig. 10 auch rekonstruierte Audioobjekte beziehungsweise an bestimmen Positionen bereits geänderte rekonstruierte Audioobjekte dar, wie es aus der Audio-Objekt-Codierung bekannt ist. Die rekonstruierten Mehrkanalaudiosignale haben nunmehr eine maximal erreichbare Audioqualität aufgrund der Tatsache, dass eine Synchronisation der Mehrkanalerweiterungsdaten mit dem Audiosignal Sample-genau erreicht worden ist.

Fig. 3b zeigt eine spezielle Implementierung des Ausgleichers 316. Der Ausgleicher 316 hat zwei Verzögerungsblöcke, von denen ein Block 320 ein fester Verzögerungsblock mit maximaler Verzögerung sein kann und der zweite Block 322 ein Block mit variabler Verzögerung sein kann, der zwischen einer Verzögerung gleich Null und einer maximalen Verzögerung $D_{max}$ steuerbar ist. Die Steuerung findet auf der Basis des Korrelationsergebnisses 314 statt. Der Fingerabdruckkorrelator 312 liefert eine Korrelationsversatzsteuerung in Ganzzahligen (x) einer Blocklänge (ΔD). Aufgrund der Tatsache, dass jedoch die Fingerabdruckberechnung selbst im Fingerabdruck-Berechner 304 basierend auf der im Audiosignal enthaltenen Blockeinteilungsinformation vorgenommen worden ist, wird erfindungsgemäß eine Sample-genaue Synchronisation erreicht, obgleich der Fingerabdruckkorrelator lediglich eine blockbasierte Korrelation vornehmen musste. Trotz der Tatsache, dass der Fingerabdruck blockweise berechnet worden ist, also nur relativ grob den zeitlichen Verlauf des Audiosignals und entsprechend auch den zeitlichen Verlauf der Mehrkanalerweiterungsdaten wiedergibt, wird dennoch eine Sample-genaue Korrelation erreicht, allein aufgrund der Tatsache, dass die Blockeinteilung des Fingerabdruck-Berechners 304 im Synchronisierer auf die Blockeinteilung hin synchronisiert worden ist, die verwendet wurde, um die Mehrkanalerweiterungsdaten blockweise zu berechnen, und die vor allem verwendet wurde, um die Fingerabdrücke zu berechnen, die in dem Mehrkanalerweiterungsdatenstrom eingebettet sind, oder die mit den Mehrkanalerweiterungsdatenstrom in Zuordnung sind.

Bezüglich der Implementierung des Ausgleichers 316 sei darauf hingewiesen, dass auch zwei variable Verzögerungen verwendet werden können, so dass das Korrelationsergebnis 314 beide variablen Verzögerungsstufen steuert. Auch alternative Implementierungsmöglichkeiten innerhalb eines Ausgleichers zu Synchronisationszwecken, um zeitliche Offsets zu eliminieren, können eingesetzt werden.

Nachfolgend wird bezugnehmend auf Fig. 6 eine detaillierte Implementierung des Blockdetektors 300 von Fig. 3a dargestellt, wenn die Blockeinteilungsinformation als Wasserzeichen in das Audiosignal eingebracht ist. Der Wasserzeichen-Extraktor in Fig. 6 kann zum Wasserzeichen-Einbetter von Fig. 5 analog aufgebaut sein, muss jedoch nicht in exakter Analogie aufgebaut sein.

Bei dem in Fig. 6 gezeigten Ausführungsbeispiel wird das Audiosignal mit Wasserzeichen einem Blockbilder 600 zugeführt, der aufeinander folgende Blöcke aus dem Audiosignal erzeugt. Ein Block wird dann einem Zeit-/Frequenz-Umsetzer 602 zugeführt, um den Block zu transformieren. Aufgrund der spektralen Darstellung des Blocks oder aufgrund einer separaten Berechnung ist ein psychoakustisches Modul 604 in der Lage, eine Maskierungsschwelle zu berechnen, um den Block des Audiosignals unter Verwendung dieser Maskierungsschwelle einer Vorfilterung in einem Vorfilter 606 zu unterziehen. Die Implementierung des Moduls 604 und des Vorfilters 606 dienen dazu, die Detektionsgenauigkeit für das Wasserzeichen zu erhöhen. Sie können auch weg gelassen werden, so dass der Ausgang des Zeit-/Frequenz-Umsetzers 602 direkt mit einem Korrelator 608 gekoppelt ist. Der Korrelator 608 ist ausgebildet, um die bekannte Pseudorauschsequenz 500, die bereits bei der Wasserzeicheneinbettung in Fig. 5 verwendet worden ist, nach einer Zeit-/Frequenz-Umsetzung in einem Umsetzer 502 mit einem Block des Audiosignals zu korrelieren.

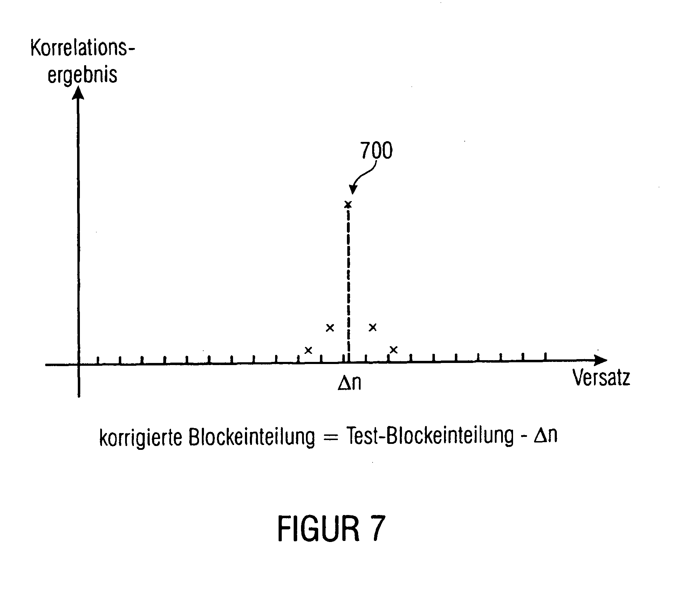

Zur Blockbildung im Block 600 wird eine Test-Blockeinteilung vorgegeben, die nicht unbedingt der endgültigen Blockeinteilung entsprechen muss. Stattdessen wird nunmehr der Korrelator 608 über mehrere Blöcke hinweg, beispielsweise über zwanzig oder sogar noch mehr Blöcke hinweg eine Korrelation durchführen. Hierbei wird in dem Korrelator 608 das Spektrum der bekannten Rauschsequenz mit dem Spektrum jedes Blocks bei verschiedenen Verzögerungswerten korreliert, so dass sich nach mehreren Blöcken ein Korrelationsergebnis 610 ergibt, das beispielsweise so ausschauen könnte, wie es in Fig. 7 gezeigt ist. Eine Steuerung 612 kann das Korrelationsergebnis 610 überwachen und eine Peak-Detektion durchführen. Zu diesem Zweck erkennt die Steuerung 612 einen Peak 700, der mit längerer Korrelation, also mit einer größeren Anzahl mit zur Korrelation verwendeten Blöcken immer deutlicher hervortritt. Sobald ein Korrelationspeak 700 detektiert ist, muss lediglich noch die x-Koordinate, also der Versatz $\Delta n$ ermittelt werden, bei dem sich das Korrelationsergebnis gezeigt hat. Dieser Versatz $\Delta n$ ergibt bei einem Ausführungsbeispiel der vorliegenden Erfindung die Anzahl von Abtastwerten an, um die die Test-Blockeinteilung von der tatsächlich bei der Wasserzeichenbettung verwendeten Blockeinteilung abgewichen ist. Aus diesem Wissen über die Test-Blockeinteilung und das Korrelationsergebnis 700 ermittelt die Steuerung 612 nunmehr eine korrigierte Blockeinteilung 614, z. B. gemäß der Formel, wie sie in Fig. 7 dargelegt ist. Insbesondere wird von der Test-Blockeinteilung der Versatzwert $\Delta n$ subtrahiert, um die korrigierte Blockeinteilung 614 zu berechnen, die dann von dem Fingerabdruck-Berechner 304 von Fig. 3a einzuhalten ist, um die Test-Fingerabdrücke zu berechnen.

Im Hinblick auf den beispielhaften Wasserzeichen-Extraktor in Fig. 6 sei darauf hingewiesen, dass eine Extraktion auch alternativ durchgeführt werden kann, z. B. im Zeitbereich und nicht im Frequenzbereich, dass auf die Vorfilterung auch verzichtet werden kann, und dass alternative Art und Weisen eingesetzt werden können, um die Verzögerung, also den Sample-Versatzwert $\Delta n$ zu berechnen. Eine alternative Möglichkeit hierzu besteht z. B. darin, verschiedene Test-Blockeinteilungen auszuprobieren und die Test-Blockeinteilung zu verwenden, bei der sich das beste Korrelationsergebnis entweder nach einer oder nach mehreren Blöcken ergibt. Als Korrelationsmaßnahme können auch nicht periodische Wasserzeichen, also nicht periodische Sequenzen eingesetzt werden, die sogar kürzer als eine Blocklänge sein können.

Bei einem bevorzugten Ausführungsbeispiel der vorliegenden Erfindung wird somit zur Lösung des Zuordnungsproblems eine spezielle Vorgehensweise auf Senderseite und Empfangsseite bevorzugt. Auf Senderseite kann eine Berechnung von zeitlich veränderlichen und geeigneten FingerprintInformationen aus dem korrespondierenden (Mono- oder Stereo-) Downmixaudiosignal vorgenommen werden. Ferner können diese Fingerprints regelmäßig als Synchronisationshilfe in den versendeten Mehrkanalzusatzdatenstrom eingetastet werden. Dies kann als ein Datenfeld inmitten der blockweise organisierten Spatial-Audio-Coding-Seiteninformationen erfolgen oder so, dass das Fingerprint-Signal als erste oder letzte Information des Datenblocks geschickt wird, um somit leicht hinzugefügt beziehungsweise herausgenommen werden zu können. Ferner kann ein Wasserzeichen, wie beispielsweise eine bekannte Rauschsequenz, in das zu versendende Audiosignal eingebettet werden. Dies dient dem Empfänger zur Ermittlung der Rahmenphase und zur Eliminierung eines rahmeninternen Versatzes.

Auf der Empfangsseite wird eine zweistufige Synchronisierung bevorzugt. In einer ersten Stufe wird das Wasserzeichen aus dem empfangenen Audiosignal extrahiert, und es wird die Position der Rauschsequenz ermittelt. Ferner können die Framegrenzen aufgrund ihrer Rauschsequenz durch die Position ermittelt und der Audiodatenstrom entsprechend unterteilt werden. In diesen Framegrenzen beziehungsweise Blockgrenzen können die charakteristischen Audiomerkmale, d. h. Fingerabdrücke oder Fingerprints über die nahezu gleichen Abschnitte errechnet werden, wie sie auch im Sender errechnet wurden, wodurch sich die Qualität des Ergebnisses bei einer späteren Korrelation erhöht. In einer zweiten Stufe werden dann zeitlich veränderliche und geeignete Fingerprintinformationen aus den korrespondierenden Stereo-Audio-Signal oder Mono-Audio-Signal beziehungsweise allgemein gesagt, aus dem Downmix-Signal berechnet, wobei das Downmix-Signal auch mehr als zwei Kanäle haben kann, so lange die Kanäle im Downmix-Signal eine kleinere Anzahl haben als in dem ursprünglichen Audiosignal vor dem Downmix Kanäle oder allgemein Audioobjekte sind.

Ferner können die Fingerabdrücke aus dem Mehrkanalzusatzinformationen extrahiert werden und es kann ein zeitlicher Versatz zwischen den Mehrkanalzusatzinformationen und dem empfangenen Signal über geeignete und auch über bekannte Korrelationsmethoden vorgenommen werden. Ein gesamter zeitlicher Versatz setzt sich aus der Framephase und dem Versatz zwischen Mehrkanalzusatzinformation und empfangenem Audiosignal zusammen. Ferner können das Audiosignal und die Mehrkanalzusatzinformationen für eine anschließende Mehrkanaldecodierung durch eine nachgeschaltete, aktiv geregelte Verzögerungsausgleichsstufe synchronisiert werden.

Das Mehrkanalaudiosignal wird für die Gewinnung der Mehrkanalzusatzdaten beispielsweise in Blöcke fester Größe eingeteilt. In den jeweiligen Block wird eine dem Empfänger ebenfalls bekannte Rauschsequenz eingebettet, beziehungsweise wird allgemein ein Wasserzeichen eingebettet. Im gleichen Raster wird nun blockweise gleichzeitig oder wenigstens synchronisiert zur Gewinnung der Mehrkanalzusatzdaten ein Fingerprint berechnet, der geeignet ist, die zeitliche Struktur des Signal möglichst eindeutig zu charakterisieren.

Ein Ausführungsbeispiel hierzu ist es, den Energiegehalt des aktuellen Downmixaudiosignals des Audioblocks zu verwenden, beispielsweise in logarithmierter Form, also in einer Dezibel-verwandten Darstellung. In diesem Fall ist der Fingerprint ein Maß für die zeitliche Hüllkurve des Audiosignals. Um die zu übertragende Informationsmenge zu reduzieren und die Genauigkeit des Messwerts zu steigern, kann diese Synchronisationsinformation auch als Differenz zum Energiewert des vorangegangenen Blocks mit anschließender geeigneter Entropiecodierung, wie beispielsweise einer Huffman-Codierung, einer adaptiven Skalierung und einer Quantisierung ausgedrückt werden.

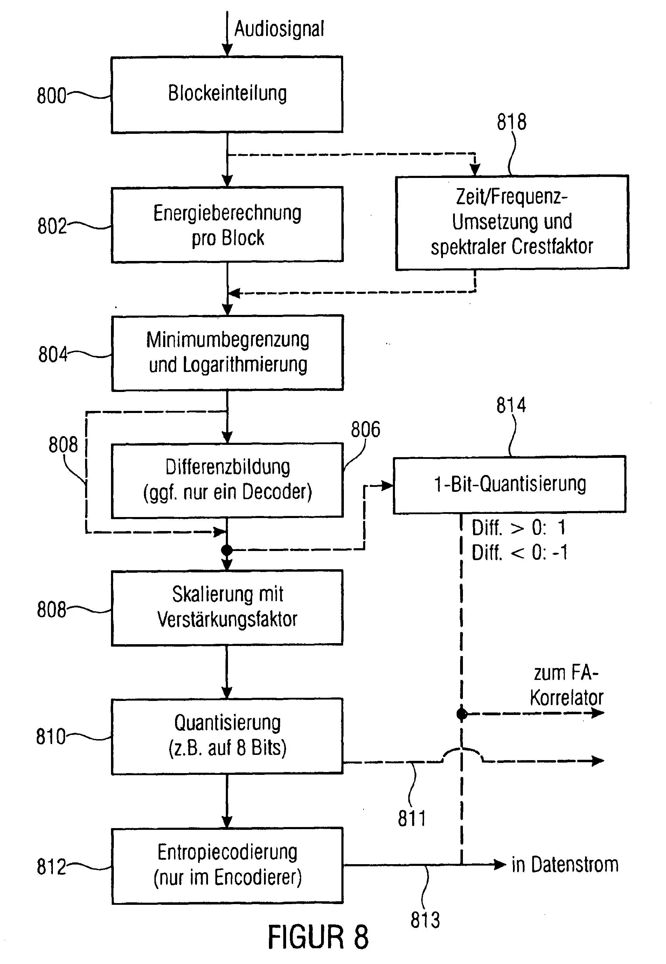

Nachfolgend wird bezugnehmend auf Fig. 8 und allgemein bezugnehmend auf Fig. 2 auf bevorzugte Ausführungsbeispiele zur Berechnung eines Fingerprints eingegangen.

Nach einer Blockeinteilung in einem Blockeinteilungsschritt 800 liegt das Audiosignal in aufeinander folgenden Blöcken vor. Hierauf wird eine Fingerabdruckwertberechnung gemäß Block 104b von Fig. 2 vorgenommen, wobei der Fingerabdruckwert beispielsweise ein Energiewert pro Block sein kann, wie es in einem Schritt 802 dargestellt ist. Wenn das Audiosignal ein Stereoaudiosignal ist, wird eine Energieberechnung des Downmixaudiosignals im aktuellen Block gemäß der folgenden Gleichung vorgenommen:

$$E_{Monosumme} = \sum_{i=0}^{1152} s_{left}(i)^2 + s_{right}(i)^2$$

Insbesondere steht der Signalwert $s_{left}(i)$ mit der Nummer i für einen zeitlichen Abtastwerte eines linken Kanals des Audiosignals. $s_{right}(i)$ steht für den i-ten Abtastwert eines rechten Kanals des Audiosignals. Bei dem gezeigten Ausführungsbeispiel beträgt die Blocklänge 1152 Audioabtastwerte, weshalb die 1153 Audioabtastwerte (einschließlich des Abtastwerts für i = 0) sowohl vom linken als auch vom rechten Downmixkanal jeweils quadriert und aufsummiert werden. Ist das Audiosignal ein monophones Audiosignal, so entfällt die Summierung. Ist das Audiosignal ein Signal mit z. B. drei Kanälen, so werden die quadrierten Abtastwerte von drei Kanälen aufsummiert. Ferner wird es bevorzugt, vor der Berechnung die (nicht aussagekräftigen) Gleichanteile der Downmixaudiosignale zu entfernen.

In einem Schritt 804 wird nunmehr vorzugsweise eine Minimumbegrenzung der Energie zwecks einer anschließenden logarithmischen Darstellung vorgenommen. Für eine Dezibelverwandte Bewertung der Energie wird ein minimaler Energie-Offset $E_{offset}$ beaufschlagt, damit sich im Falle der Nullenergie eine sinnvolle logarithmische Rechnung ergibt. Diese Energiemaßzahl in dB beschreibt dabei einen Zahlenbereich von 0 bis 90 (dB) bei einer Audiosignalauflösung von 16 Bit. In einem Block 804 wird somit folgende Gleichung implementiert:

$$E_{(db)} = 10 * \log(E_{Monosumme} + E_{offset})$$

Vorzugsweise wird für eine exakte Bestimmung des zeitlichen Versatzes zwischen den Mehrkanalzusatzinformationen und dem empfangenen Audiosignal nicht der absolute Energie-Höhekurvenwert verwendet, sondern vielmehr die Steigung beziehungsweise Steilheit der Signalhüllkurve. Hierbei wird für die Korrelationsmessung in dem Fingerabdruck-Korrelator 312 von Fig. 3a die Steigung der Energie-Hüllkurve herangezogen. Technisch gesehen, wird diese Signalableitung durch eine Differenzbildung des Energiewertes mit dem des vorangegangenen Blocks berechnet und zwar gemäß folgender Gleichung:

$$E_{db(diff)} = E_{db}(aktueller\_Block) - E_{db}(vorangegangener\_Block)$$

$E_{db(Diff)}$ ist der Differenzwert der Energiewerte zweier vorausgehender Blöcke, und zwar in einer dB-Darstellung, während $E_{db}$ die Energie in dB des aktuellen Blocks beziehungsweise des vorangegangenen Blocks ist, wie es aus der vorstehenden Gleichung selbst erklärend ist. Diese Differenzbildung der Energien wird in einem Schritt 806 durchgeführt.

Es sei darauf hingewiesen, dass dieser Schritt z. B. nur im Encoder, also im Fingerabdruck-Berechner 104 von Fig. 1 vollzogen wird, dahingehend, dass der Fingerabdruck, der in die Mehrkanalerweiterungsdaten eingebettet wird, aus differenzcodierten Werten besteht.

Alternativ kann der Schritt 806 der Differenzbildung auch rein decodiererseitig implementiert werden, also in dem Fingerabdruck-Berechner 304 von Fig. 3a. In diesem Fall besteht der übertragene Fingerabdruck nur aus nicht differenzcodierten, und die Differenzbildung gemäß dem Schritt 806 wird erst im Decodierer vorgenommen. Diese Möglichkeit ist durch die gestrichelte Signalflusslinie 808 dargestellt, die den Differenzbildungsblock 806 überbrückt. Diese letztere Möglichkeit 808 hat den Vorteil, dass der Fingerabdruck noch Informationen über die absolute Energie des Downmixsignals enthält, benötigt aber eine etwas höhere Fingerprintwortlänge.

Während die Blöcke 802, 804, 806 zur Fingerabdruckwertberechnung gemäß 104b von Fig. 2 gezählt werden können, werden die nachfolgenden Schritte 808 (Skalierung mit Verstärkungsfaktor), 810 (Quantisierung), 812 (Entropiecodierung) oder auch 1-Bit-Quantisierung in einem Block 814 zu einer Fingerabdrucknachverarbeitung gemäß dem Fingerabdrucknachverarbeiter 104c gezählt.

Bei der Skalierung der Energie (Hüllkurve des Signals) für eine optimale Aussteuerung gemäß dem Block 808 wird sichergestellt, dass bei der anschließenden Quantisierung dieses Fingerabdrucks sowohl der Zahlenbereich maximal ausgenutzt als auch die Auflösung bei geringen Energiewerten verbessert wird. Hierzu wird eine zusätzliche Skalierung beziehungsweise Verstärkung eingeführt. Diese kann entweder als feste oder statische Gewichtungsgröße oder über eine an das Hüllkurvensignal angepasste dynamische Verstärkungsregelung realisiert werden. Auch Kombinationen einer statischen Gewichtungsgröße sowie einer angepassten dynamischen Verstärkungsregelung sind verwendbar. Insbesondere wird gemäß folgender Gleichung vorgegangen:

$$E_{skaliert} = E_{db(diff)} * A_{Verstärkung}(t)$$

$E_{skaliert}$ stellt hierbei die skalierte Energie dar. $E_{db(diff)}$ stellt die durch die Differenzbildung im Block 806 berechnete Differenzenergie in dB dar, und $A_{Verstärkung}$ ist der Verstärkungsfaktor, der von der Zeit t abhängig sein kann, wenn es sich um eine insbesondere dynamische Verstärkungsregelung handelt. Der Verstärkungsfaktor wird von dem Hüllkurvensignal dahingehend abhängen, dass mit größerer Hüllkurve der Verstärkungsfaktor kleiner wird und mit kleinerer Hüllkurve der Verstärkungsfaktor größer wird, um eine möglichst gleichmäßige Aussteuerung des zur Verfügung stehenden Zahlenbereichs zu erhalten. Der Verstärkungsfaktor kann insbesondere im Fingerabdruck-Berechner 304 durch Messen der Energie des übertragenen Audiosignals nachgebildet werden, so dass der Verstärkungsfaktor nicht explizit übertragen werden muss.

In einem Block 810 wird der vom Block 808 berechnete Fingerabdruck quantisiert. Dies wird durchgeführt, um den Fingerprint für die Eintastung in die Mehrkanalzusatzinformationen vorzubereiten. Diese reduzierte Fingerprintauflösung hat sich als guter Kompromiss hinsichtlich Bitbedarf und Zuverlässigkeit der Verzögerungsdetektion bewährt. Vor allem Überläufe von > 255 können dabei mit einer Sättigungskennlinie auf den Maximalwert von 255 begrenzt werden, wie es beispielsweise folgendermaßen gleichungsmäßig dargestellt werden kann:

$$E_{quantisiert} = Q_{8bit}\left[ Sättigung \frac{255}{0}(E_{skaliert}) \right]$$

Equantisiert ist hierbei der quantisierte Energiewert und stellt einen Quantisierungsindex dar, der 8 Bit hat. $Q_{8Bit}$ ist die Quantisierungsoperation, die einem Wert > 255 den Quantisierungsindex für den Maximalwert 255 zuweist. Es sei darauf hingewiesen, dass auch feinere Quantisierungen mit mehr als 8 Bit oder gröbere Quantisierungen mit weniger als 8 Bit genommen werden können, wobei bei gröber werdender Quantisierung der Zusatzbitbedarf abnimmt, während bei feinerer Quantisierung mit mehr Bits der Zusatzaufwand an Bits ansteigt, jedoch auch die Genauigkeit ansteigt.

In einem Block 812 kann hierauf eine Entropiecodierung des Fingerprints stattfinden. Durch die Auswertung von statistischen Eigenschaften des Fingerprints kann der Bitbedarf für den quantisierten Fingerprint weiter reduziert werden. Ein geeignetes Entropieverfahren ist beispielsweise die Huffman-Codierung. Statistisch unterschiedliche Häufigkeiten von Fingerprintwerten können durch verschiedene Codelängen ausgedrückt werden und somit im Mittel den Bitbedarf der Fingerprintdarstellung reduzieren.

Das Ergebnis des Entropiecodierungsblocks 812 wird dann in den Erweiterungskanaldatenstrom geschrieben, wie es bei 813 dargestellt ist. Alternativ können auch nicht-entropie-codierte Fingerprints als quantisierte Werte in den Bitstrom geschrieben werden, wie es bei 811 dargestellt ist.

Alternativ zur Energieberechnung pro Block im Schritt 802 kann auch ein anderer Fingerabdruckwert berechnet werden, wie es im Block 818 dargestellt ist.

Alternativ zur Energie eines Blocks kann auch der Crestfaktor des Leistungsddichtespektrums (PSD-Crest) berechnet werden. Der Crestfaktor berechnet sich allgemein als Quotient zwischen dem Maximalwert XMax des Signals in einem Block zum arithmetischen Mittelwert der Signale $X_n$ (z.B. Spektralwerte) in dem Block, wie es in der nachfolgenden Gleichung

$$y = \frac{XMax}{\frac{\sum\limits_{i=1}^{n} X_n}{n}}$$

beispielhaft dargestellt ist.

Um eine robustere Synchronisierung zu erreichen, kann ferner ein weiteres Verfahren eingesetzt werden. Anstelle des Nachverarbeitens mittels den Blöcken 808, 810, 812 kann als alternative Fingerabdrucknachverarbeitung 104c (Fig. 2) auch eine 1-Bit-Quantisierung verwendet werden, wie sie im Block 814 dargestellt ist. Hier wird direkt nach der Berechnung und der Differenzbildung des Fingerprints gemäß 802 oder 818 im Encodierer zusätzlich eine 1-Bit-Quantisierung durchgeführt. Es hat sich gezeigt, dass sich dadurch die Genauigkeit der Korrelation erhöhen lässt. Diese 1-Bit-Quantisierung wird so realisiert, dass der Fingerprint gleich 1 ist, wenn der neue Wert größer als der alte ist (Steigung positiv) und gleich -1 ist, wenn die Steigung negativ ist. Eine negative Steigung ist dann erreicht, wenn der neue Wert kleiner als der alte Wert ist.

Zusätzlich zur Verbesserung der Synchronisationsergebnisse wirkt sich diese Quantisierung auch auf die benötigte Bandbreite für die Übertragung des Fingerprints aus. Mussten vorher für den Fingerprint mindestens 8 Bit eingesetzt werden, um einen ausreichend genauen Wert bereitzuhalten, genügt hier ein einziges Bit. Da der Fingerprint und sein 1-Bit-Pendant schon im Sender ermittelt werden, erreicht man eine genauere Berechnung der Differenz, da der eigentliche Fingerprint mit maximaler Auflösung vorliegt und so auch minimale Änderungen zwischen den Fingerprints sowohl im Sender als auch im Empfänger berücksichtigt werden können. Ferner hat sich herausgestellt, dass sich die meisten aufeinander folgenden Fingerprints nur minimal unterscheiden. Dieser Unterschied wird jedoch durch eine Quantisierung vor der Differenzbildung zunichte gemacht werden.

Je nach Implementierung, und wenn eine blockweise Genauigkeit ausreichend ist, kann die 1-Bit-Quantisierung als spezielle Fingerabdruck-Nachverarbeitung auch unabhängig davon verwendet werden, ob ein Audiosignal mit ZusatzInformationen vorliegt oder nicht, da die 1-Bit-Quantisierung auf der Basis einer Differenzcodierung bereits an sich ein robustes und dennoch genaues Fingerabdruck-Verfahren ist, das auch zu anderen Zwecken als zur Synchronisation, z. B. zu Zwecken der Identifizierung oder Klassifizierung eingesetzt werden kann.

Wie es anhand von Fig. 11a dann dargestellt worden ist, wird eine Berechnung der Mehrkanalzusatzdaten unter Zuhilfenahme der Mehrkanalaudiodaten durchgeführt. Die hierbei berechneten Mehrkanalzusatzinformationen werden anschließend durch die neu hinzukommende Synchronisationsinformation in Form der berechneten Fingerabdrücke durch geeignetes Einbetten in den Bitstrom erweitert.

Die bevorzugte Wortmarken-Fingerprint-Hybrid-Lösung erlaubt es einem Synchronisierer, einen zeitlichen Versatz von Downmixsignal und Zusatzdaten zu erkennen und eine zeitkorrekte Anpassung, also eine Verzögerungskompensation zwischen dem Audiosignal und den Mehrkanalerweiterungsdaten in der Größenordnung von +/- einem Sample-Wert zu realisieren. Somit kann die Mehrkanalzuordnung im Empfänger fast vollständig, d. h. bis auf einen kaum wahrnehmbaren Zeitunterschied von wenigen Samples rekonstruiert werden, welches sich nicht nennenswert auf die Qualität des rekonstruierten Mehrkanalaudiosignals auswirkt.

Abhängig von den Gegebenheiten kann das erfindungsgemäße Verfahren in Hardware oder in Software implementiert werden. Die Implementierung kann auf einem digitalen Speichermedium, insbesondere einer Diskette, CD oder DVD mit elektronisch auslesbaren Steuersignalen erfolgen, die so mit einem programmierbaren Computersystem zusammenwirken können, dass das Verfahren ausgeführt wird. Allgemein besteht die Erfindung somit auch in einem Computer-Programm-Produkt mit einem auf einem maschinenlesbaren Träger gespeicherten Programmcode zur Durchführung des erfindungsgemäßen Verfahrens, wenn das Computer-Programm-Produkt auf einem Rechner abläuft. In anderen Worten ausgedrückt, kann die Erfindung somit als ein Computer-Programm mit einem Programmcode zur Durchführung des Verfahrens realisiert werden, wenn das Computer-Programm auf einem Computer abläuft.

**Patentansprüche**

1. Vorrichtung (1000) zum Synchronisieren von Mehrkanalerweiterungsdaten (132) mit einem Audiosignal (114), das Blockeinteilungsinformationen aufweist, um sicherzustellen, dass Test-Audiosignal-Fingerabdrücke (306) auf derselben Blockeinteilung basieren wie Referenz-Audiosignal-Fingerabdrücke, wobei den Mehrkanalerweiterungsdaten Referenz-Audiosignal-Fingerabdruck-Informationen zugeordnet sind, mit folgenden Merkmalen:

   einem Blockdetektor (300) zum Detektieren der Blockeinteilungsinformationen (302) in dem Audiosignal (114);
   einen Fingerabdruck-Berechner (304) zum Berechnen eines Fingerabdrucks pro Block des Audiosignals für eine Mehrzahl von aufeinander folgenden Blöcken, um eine Folge von Test-Audiosignal-Fingerabdrücken zu erhalten, wobei der Fingerabdruck-Berechner (304) ausgebildet ist, um die Blockeinteilungsinformationen (302) zu verwenden, um die Folge von Test-Audiosignal-Fingerabdrücken (306) zu berechnen;
   einem Fingerabdruckextraktor (308) zum Extrahieren einer Folge von Referenz-Audiosignal-Fingerabdrücken aus den Referenz-Audiosignal-Fingerabdruckinformationen, die den Mehrkanalerweiterungsdaten (132) zugeordnet sind;
   einem Fingerabdruckkorrelator (312) zum Korrelieren der Folge von Test-Audiosignal-Fingerabdrücken und der Folge von Referenz-Audiosignal-Fingerabdrücken; und
   einem Ausgleicher (316) zum Reduzieren oder Eliminieren eines zeitlichen Versatzes zwischen den Mehrkanalerweiterungsdaten (132) und dem Audiosignal, basierend auf einem Korrelationsergebnis (314).

2. Vorrichtung nach Anspruch 1, bei der der Blockdetektor (300) ausgebildet ist, eine Blockgrenze einer regelmäßigen Blockeinteilung zu detektieren, und
   bei der der Fingerabdruck-Berechner (304) ausgebildet ist, um das Audiosignal ausgehend von der Blockgrenze in aufeinander folgende Blöcke gleicher Länge einzuteilen, und um für jeden Block einen Fingerabdruck zu berechnen, um die Folge von Test-Audiosignal-Fingerabdrücken zu erhalten.

3. Vorrichtung nach Anspruch 1 oder 2, bei der die Mehrkanalerweiterungsdaten (132) eine Blockstruktur haben, wobei ein Block von Mehrkanalerweiterungsdaten einem Block des Audiosignals (114) zugeordnet ist, um aus dem Audiosignal für den Block und den Mehrkanalerweiterungsdaten für den Block ein Mehrkanalaudiosignal zu erzeugen (1102), das ein ursprüngliches Mehrkanalaudiosignal approximiert,
   wobei jedem Block von Mehrkanalerweiterungsdaten ein Referenzfingerabdruck zugeordnet ist, der von einem Block des Audiosignals abgeleitet ist, der von einem jeweiligen Block der Mehrkanalaudiosignale abgeleitet ist, von denen die Mehrkanalerweiterungsdaten des Mehrkanalaudiosignals abgeleitet sind, oder der zu dem Block der Mehrkanalaudiosignale eine bekannte Zuordnung hat.

4. Vorrichtung nach einem der vorhergehenden Ansprüche, bei dem die Blockeinteilungsinformationen (302) ein Wasserzeichen aufweisen, das in das Audiosignal eingebettet ist, und
   bei der der Blockdetektor (300) einen Wasserzeichen-Extraktor hat, um das Wasserzeichen in dem Audiosignal zu detektieren.

5. Vorrichtung nach Anspruch 4, bei der das Wasserzeichen in einen Block des Audiosignals eingebettet ist, so dass sich das Wasserzeichen in aufeinander folgenden Blöcken des Audiosignals wiederholt, und
   bei der der Blockdetektor (300) ausgebildet ist, um eine Korrelation (608) zwischen einer bekannten Rauschsequenz (500) und dem Audiosignal auf der Basis einer Test-Blockeinteilung über mehrere Blöcke durchzuführen, und
   wobei der Blockdetektor (300) eine Steuerung (612) aufweist, die ausgebildet ist, um eine Korrelationsspitze in einem Ergebnis der Korrelation (608) zu detektieren, die einen Versatz in Abtastwerten von einer ursprünglichen Blockeinteilung zu der Test-Blockeinteilung angibt.

6. Vorrichtung nach einem der vorhergehenden Ansprüche, bei der der Fingerabdruck-Berechner (304) ausgebildet ist, um pro Block eine Energie des Audiosignals zu berechnen.

7. Vorrichtung nach einem der vorhergehenden Ansprüche, bei der der Fingerabdruck-Berechner ausgebildet ist, um pro Block eine Differenz eines Fingerabdruckswerts für einen aktuellen Block und einen Fingerabdruckwert für einen vorhergehenden Block zu berechnen.

8. Vorrichtung nach Anspruch 6 oder 7, bei der die Referenz-Audiosignal-Fingerabdruck-Informationen eine Folge von absoluten Energiewerten des Audiosignals aufweisen, und
   bei der der Fingerabdruck-Extraktor (308) ausgebildet ist, um zwischen zwei aufeinander folgenden absoluten Energiewerten einen Differenzwert zu berechnen, so dass aus der Folge von absoluten Energiewerten eine Folge von Differenzwerten erhalten wird, die die Folge von Referenz-Audiosignal-Fingerabdrücken darstellt.

9. Vorrichtung nach einem der vorhergehenden Ansprüche, bei der die Referenz-Audiosignal-Fingerabdruck-Informationen Entropie-codierte Werte sind, und
bei der der Fingerabdruck-Extraktor (308) ausgebildet ist, um eine Entropie-Decodierung durchzuführen.

10. Vorrichtung nach einem der vorhergehenden Ansprüche, bei der der Fingerabdruck-Extraktor (308) oder der Fingerabdruck-Berechner (304) ausgebildet sind, um eine statische oder eine an eine Hüllkurve des Audiosignals angepasste dynamische Verstärkungsregelung durchzuführen (808).

11. Vorrichtung nach einem der Ansprüche 1 bis 5, bei der der Fingerabdruck-Berechner (304) ausgebildet ist, um für einen Block des Audiosignals einen Quotienten aus einem Maximalwert des Audiosignals und einem arithmetischen Mittelwert des Audiosignals im Block zu berechnen (818).

12. Vorrichtung nach einem der vorhergehenden Ansprüche, bei der der Fingerabdruck-Berechner (304) ausgebildet ist, um pro Block einen Wert für das Audiosignal zu berechnen, und um eine 1-Bit-Quantisierung (814) durchzuführen, wobei ein erster binärer Wert erhalten wird, wenn der Wert eines aktuellen Blocks größer als ein Wert eines vorausgehenden Blocks ist, und wobei ein zweiter binärer Wert erhalten wird, wenn der Wert des aktuellen Blocks kleiner als der Wert des vorausgehenden Blocks ist.

13. Verfahren (1000) zum Synchronisieren von Mehrkanalerweiterungsdaten (132) mit einem Audiosignal (114), das Blockeinteilungsinformationen aufweist, um sicherzustellen, dass Test-Audiosignal-Fingerabdrücke (306) auf derselben Blockeinteilung basieren wie Referenz-Audiosignal-Fingerabdrücke, wobei den Mehrkanalerweiterungsdaten Referenz-Audiosignal-Fingerabdruck-Informationen zugeordnet sind, mit:

   Detektieren (300) der Blockeinteilungsinformationen (302) in dem Audiosignal (114);
   Berechnen (304) eines Fingerabdrucks pro Block des Audiosignals für eine Mehrzahl von aufeinander folgenden Blöcken, um eine Folge von Test-Audiosignal-Fingerabdrücken zu erhalten, wobei die Blockeinteilungsinformationen (302) verwendet werden, um die Folge von Test-Audiosignal-Fingerabdrücken (306) zu berechnen;
   Extrahieren (308) einer Folge von Referenz-Audiosignal-Fingerabdrücken aus den Referenz-Audiosignal-Fingerabdruckinformationen, die den Mehrkanalerweiterungsdaten (132) zugeordnet sind;
   Korrelieren (312) der Folge von Test-Audiosignal-Fingerabdrücken und der Folge von Referenz-Audiosignal-Fingerabdrücken; und
   Reduzieren (316) oder Eliminieren eines zeitlichen Versatzes zwischen den Mehrkanalerweiterungsdaten (132) und dem Audiosignal, basierend auf einem Korrelationsergebnis (314).

14. Vorrichtung (904) zum Verarbeiten eines Audiosignals (102) mit folgenden Merkmalen:

   einem Fingerabdruck-Berechner (104) zum Berechnen eines Fingerabdrucks pro Block des Audiosignals (100, 102) für eine Folge von aufeinander folgenden Blöcken, um eine Folge von Referenz-Audiosignal-Fingerabdruck-Informationen zu erhalten, wobei der Fingerabdruck-Berechner (104) ausgebildet ist, um eine vorbestimmte Blockeinteilungsinformation (106) zu verwenden, um die Folge von Referenz-Audiosignal-Fingerabdruck-Informationen zu berechnen, oder um verwendete Blockeinteilungsinformationen (110) in Zuordnung zu dem Audiosignal zu speichern, um sicherzustellen, dass Test-Audiosignal-Fingerabdrücke (306) auf derselben Blockeinteilung basieren wie Referenz-Audiosignal-Fingerabdrücke,
   einem Fingerabdruck-Informationen-Einbetter (122) zum Zuordnen der Referenz-Audiosignal-Fingerabdruck-Informationen zu den Mehrkanalerweiterungsdaten (124), wobei die Mehrkanalerweiterungsdaten (124) so ausgebildet sind, dass mit einem Block der Mehrkanalerweiterungsdaten zusammen mit einem Block des Audiosignals eine Approximation eines Multikanalaudiosignals ermittelbar ist,
   wobei der Fingerabdruck-Informationen-Einbetter (122) ausgebildet ist, um die Referenz-Fingerabdruck-Informationen für den Block des Audiosignals in den Block der Mehrkanalerweiterungsdaten einzubetten oder in einer Zuordnung zu dem Block der Mehrkanalerweiterungsdaten in ein Ausgangssignal (132) einzufügen; und
   einer Ausgangsschnittstelle (116) zum Ausgeben des Ausgangssignals (132).

15. Vorrichtung nach Anspruch 14, bei der das Audisignal (100) die Blockeinteilungsinformationen aufweist und der Fingerabdruck-Berechner (104) ausgebildet ist, um die Blockeinteilungsinformationen aus dem Audiosignal zu ermitteln (108).

**16.** Vorrichtung nach Anspruch 14, bei der das Audiosignal (102) die Blockeinteilungsinformation nicht umfasst und der Fingerabdruck-Berechner (104) ausgebildet ist, um die Blockeinteilungsinformationen (110) einem Blockeinteilungsinformation-Einbetter (112) zu liefern, damit derselbe die Blockeinteilungsinformationen in das Audiosignal einbettet, und

bei der die Ausgangsschnittstelle (116) ausgebildet ist, um ferner das Audiosignal (114) mit den eingebetteten Blockeinteilungsinformationen auszugeben.

**17.** Vorrichtung nach Anspruch 16, bei der der Blockeinteilungsinformationen-Einbetter (112) ausgebildet ist, um als Blockeinteilungsinformation ein Wasserzeichen in das Audiosignal zu betten.

**18.** Vorrichtung nach Anspruch 17, bei der der Fingerabdruck-Berechner (104) ausgebildet ist, um eine Blockeinteilung des Audiosignals durchzuführen, und bei dem der Blockeinteilungssinformations-Einbetter (112) ausgebildet ist, um in diesen Block ein Wasserzeichen einzubetten, das zu einem in einem vorherigen oder nachfolgenden Block eingebetteten Wasserzeichen identisch ist.

**19.** Vorrichtung nach Anspruch 17 oder 18, bei der der Blockeinteilungsinformation-Einbetter (112) ausgebildet ist, um als Wasserzeichen eine vorbestimmte Pseudorauschsequenz einzubetten.

**20.** Vorrichtung nach einem der Ansprüche 14 bis 19, bei der der Fingerabdruck-Berechner ausgebildet ist, um eine Energieberechnung (802) pro Block des Audiosignals durchzuführen.

**21.** Vorrichtung nach einem der Ansprüche 14 bis 20, bei der der Fingerabdruck-Berechner ausgebildet ist, um eine Differenzbildung (806) zwischen einem Fingerabdruckwert eines vorhergehenden Blocks und einem Fingerabdruckwert eines aktuellen Blocks durchzuführen.

**22.** Vorrichtung nach einem der Ansprüche 14 bis 21, bei der der Fingerabdruck-Berechner ausgebildet ist, um Werte des aktuellen Blocks und des vorhergehenden Blocks ohne Differenzbildung (808) als Referenz-Audiosignal-Fingerabdruck-Informationen auszugeben.

**23.** Vorrichtung nach einem der Ansprüche 14 bis 22, bei der der Fingerabdruck-Berechner (104) ausgebildet ist, um eine Quantisierung (810) und eine EntropieCodierung (812) durchzuführen.

**24.** Vorrichtung nach einem der Ansprüche 14 bis 23, bei der der Fingerabdruck-Berechner (104) ausgebildet ist, um eine statische oder eine an eine Hüllkurve des Audiosignals angepasste dynamische Verstärkungsregelung (808) durchzuführen.

**25.** Vorrichtung nach einem der Ansprüche 14 bis 24, bei der der Fingerabdruck-Berechner (104) ausgebildet ist, um für einen Block des Audiosignals einen Quotient aus einem Maximalwert des Audiosignals und einem arithmetischen Mittelwert des Audiosignals in dem Block zu berechnen (818).

**26.** Vorrichtung nach einem der Ansprüche 14 bis 20, bei der der Fingerabdruck-Berechner (104) ausgebildet ist, um pro Block einen Wert für das Audiosignal zu berechnen, und um eine 1-Bit-Quantisierung (814) durchzuführen, wobei ein erster binärer Wert erhalten wird, wenn der Werte eines aktuellen Blocks größer als ein Wert eines vorausgehenden Blocks ist, und bei der ein zweiter binärer Wert erhalten wird, wenn der Wert des aktuellen Blocks kleiner als des vorausgehenden Blocks ist.

**27.** Verfahren (904) zum Verarbeiten eines Audiosignals (102), mit:

Berechnen (104) eines Fingerabdrucks pro Block des Audiosignals (100, 102) für eine Folge von aufeinander folgenden Blöcken, um eine Folge von Referenz-Audiosignal-Fingerabdruck-Informationen zu erhalten, wobei eine vorbestimmte Blockeinteilungsinformation (106) verwendet wird, um die Folge von Referenz-Audiosignal-Fingerabdruck-Informationen zu berechnen, oder wobei eine verwendete Blockeinteilungsinformationen (110) in Zuordnung zu dem Audiosignal gespeichert wird, um sicherzustellen, dass Test-Audiosignal-Fingerabdrücke (306) auf derselben Blockeinteilung basieren wie Referenz-Audiosignal-Fingerabdrücke,

Zuordnen (122) der Referenz-Audiosignal-Fingerabdruck-Informationen zu den Mehrkanalerweiterungsdaten (124), wobei die Mehrkanalerweiterungsdaten (124) so ausgebildet sind, dass mit einem Block der Mehrkanalerweiterungsdaten zusammen mit einem Block des Audiosignals eine Approximation eines Multikanalaudiosignals ermittelbar ist,

wobei die Referenz-Fingerabdruck-Informationen für den Block des Audiosignals in den Block der Mehrkanalerweiterungsdaten eingebettet oder in einer Zuordnung zu dem Block der Mehrkanalerweiterungsdaten in ein Ausgangssignal (132) eingefügt werden; und
Ausgeben (116) des Ausgangssignals (132).

**28.** Computer-Programm mit einem Programmcode zum Ausführen des Verfahrens gemäß Patentanspruch 13 oder 27, wenn das Computer-Programm auf einem Rechner abläuft.

## Claims

**1.** An apparatus (1000) for synchronizing multichannel extension data (132) with an audio signal (114) comprising block division information, in order to ensure that test audio signal fingerprints (306) are based on the same block division as reference audio signal fingerprints, wherein reference audio signal fingerprint information are associated with the multichannel extension data, comprising:

a block detector (300) for detecting the block division information (302) in the audio signal (114);
a fingerprint calculator (304) for calculating one fingerprint per block of the audio signal for a plurality of subsequent blocks in order to obtain a sequence of test audio signal fingerprints, wherein the fingerprint calculator (304) is implemented to use the block division information (302) for calculating the sequence of test audio signal fingerprints (306);
a fingerprint extractor (308) for extracting a sequence of reference audio signal fingerprints from the reference audio signal fingerprint information associated with the multichannel extension data (132);
a fingerprint correlator (312) for correlating the sequence of test audio signal fingerprints and the sequence of reference audio signal fingerprints; and
a compensator (316) for reducing or eliminating a time offset between the multichannel extension data (132) and the audio signal based on a correlation result (314).

**2.** The apparatus according to claim 1, wherein the block detector (300) is implemented to detect a block boundary of a regular block division, and
wherein the fingerprint calculator (304) is implemented to divide the audio signal, starting from the block boundary, into subsequent blocks of equal length and to calculate a fingerprint for every block in order to obtain the sequence of test audio signal fingerprints.

**3.** The apparatus according to claims 1 or 2, wherein the multichannel extension data (132) comprise a block structure, wherein one block of multichannel extension data is associated with a block of the audio signal (114) in order to generate (1102) a multichannel audio signal from the audio signal for the block and the multichannel extension data for the block, which approximates an original multichannel audio signal,
wherein a reference fingerprint is associated with every block of multichannel extension data, which is derived from a block of the audio signal derived from a respective block of the multichannel audio signals from which the multichannel extension data of the multichannel audio signal are derived, or which has a known association with the block of the multichannel audio signals.

**4.** The apparatus according to any of the previous claims, wherein the block division information (302) comprise a watermark embedded into the audio signal, and wherein the block detector (300) comprises a watermark extractor for detecting the watermark in the audio signal.

**5.** The apparatus according to claim 4, wherein the watermark is embedded into a block of the audio signal, such that the watermark is repeated in subsequent blocks of the audio signal, and
wherein the block detector (300) is implemented to perform correlation (608) between a known noise sequence (500) and the audio signal based on a test block division across several blocks, and
wherein the block detector (300) comprises a control (612) that is implemented to detect a correlation peak in a result of the correlation (608) indicating an offset in samples from an original block division to the test block division.

**6.** The apparatus according to any of the previous claims, wherein the fingerprint calculator (304) is implemented to calculate, per block, an energy of the audio signal.

**7.** The apparatus according to any of the previous claims, wherein the fingerprint calculator is implemented to calculate, per block, a difference of a fingerprint value for a current block and a fingerprint value for a previous block.

8. The apparatus according to claims 6 or 7, wherein the reference audio signal fingerprint information comprise a sequence of absolute energy values of the audio signal, and
wherein the fingerprint extractor (308) is implemented to calculate a difference value between two subsequent absolute energy values, such that a sequence of difference values is obtained from the sequence of absolute energy values, which represents the sequence of reference audio signal fingerprints.

9. The apparatus according to any of the previous claims, wherein the reference audio signal fingerprint information consist of entropy coded values, and
wherein the fingerprint extractor (308) is implemented to perform entropy decoding.

10. The apparatus according to any of the previous claims, wherein the fingerprint extractor (308) or the fingerprint calculator (304) are implemented to perform (808) a static or a dynamic amplification regulation adapted to an envelope of the audio signal.

11. The apparatus according to any of claims 1 to 5, wherein the fingerprint calculator (304) is implemented to calculate (818), for a block of the audio signal, a quotient of a maximum value of the audio signal and an arithmetic average value of the audio signal in the block.

12. The apparatus according to any of the previous claims, wherein the fingerprint calculator (304) is implemented to calculate, per block, a value for the audio signal and to perform (814) 1-bit quantization, wherein a first binary value is obtained when the value of a current block is higher than a value of a previous block, and wherein a second binary value is obtained when the value of the current block is smaller than the value of the previous block.

13. A method (1000) for synchronizing multichannel extension data (132) with an audio signal (114) comprising block division information, in order to ensure that test audio signal fingerprints (306) are based on the same block division as reference audio signal fingerprints, wherein reference audio signal fingerprint information are associated with the multichannel extension data, comprising:

   detecting (300) the block division information (302) in the audio signal (114);
   calculating (304) a fingerprint per block of the audio signal for a plurality of subsequent blocks in order to obtain a sequence of test audio signal fingerprints, wherein the block division information (302) are used for calculating the sequence of test audio signal fingerprints (306);
   extracting (308) a sequence of reference audio signal fingerprints from the reference audio signal fingerprint information associated with the multichannel extension data (132);
   correlating (312) the sequence of test audio signal fingerprints and the sequence of reference audio signal fingerprints; and
   reducing (316) or eliminating a time offset between the multichannel extension data (132) and the audio signal based on a correlation result (314).

14. An apparatus (904) for processing an audio signal (102), comprising:

   a fingerprint calculator (104) for calculating a fingerprint per block of the audio signal (100, 102) for a sequence of subsequent blocks in order to obtain a sequence of reference audio signal fingerprint information, wherein the fingerprint calculator (104) is implemented to use predetermined block division information (106) for calculating the sequence of reference audio signal fingerprint information, or to store used block division information (110) in association with the audio signal, in order to ensure that test audio signal fingerprints (306) are based on the same block division as reference audio signal fingerprints,
   a fingerprint information embedder (122) for associating the reference audio signal fingerprint information with the multichannel extension data (124), wherein the multichannel extension data (124) are implemented such that an approximation of a multichannel audio signal can be determined with a block of the multichannel extension data together with a block of the audio signal,
   wherein the fingerprint information embedder (122) is implemented to embed the reference fingerprint information for the block of the audio signal into the block of the multichannel extension data or to insert it into an output signal (132) in association with the block of multichannel extension data; and
   an output interface (116) for outputting the output signal (132).

**15.** The apparatus according to claim 14, wherein the audio signal (100) comprises the block division information and the fingerprint calculator (104) is implemented to determine the block division information from the audio signal (108).

**16.** The apparatus according to claim 14, wherein the audio signal (102) does not comprise the block division information and the fingerprint calculator (104) is implemented to provide the block division information (110) to a block division information embedder (112) such that same embeds the block division information into the audio signal, and wherein the output interface (116) is further implemented to output the audio signal (114) with the embedded block division information.

**17.** The apparatus according to claim 16, wherein the block division information embedder (112) is implemented to embed, as block division information, a watermark into the audio signal.

**18.** The apparatus according to claim 17, wherein the fingerprint calculator (104) is implemented to perform a block division of the audio signal, and wherein the block division information embedder (112) is implemented to embed a watermark into this block, which is identical to a watermark embedded in a previous or subsequent block.

**19.** The apparatus according to claims 17 or 18, wherein the block division information embedder (112) is implemented to embed a predetermined pseudo noise sequence as watermark.

**20.** The apparatus according to any of claims 14 to 19, wherein the fingerprint calculator is implemented to perform one energy calculation (802) per block of the audio signal.

**21.** The apparatus according to any of claims 14 to 20, wherein the fingerprint calculator is implemented to perform a difference calculation (806) between a fingerprint value of a previous block and a fingerprint value of a current block.

**22.** The apparatus according to any of claims 14 to 21, wherein the fingerprint calculator is implemented to output values of the current block and the previous block, without difference calculation (808), as reference audio signal fingerprint information.

**23.** The apparatus according to any of claims 14 to 22, wherein the fingerprint calculator (104) is implemented to perform quantization (810) and entropy coding (812).

**24.** The apparatus according to any of claims 14 to 23, wherein the fingerprint calculator (104) is implemented to perform a static or dynamic amplification regulation (808) adapted to an envelope of the audio signal.

**25.** The apparatus according to any of claims 14 to 24, wherein the fingerprint calculator (104) is implemented to calculate (818), for a block of the audio signal, a quotient of a maximum value of the audio signal and an arithmetic average of the audio signal in the block.

**26.** The apparatus according to any of claims 14 to 20, wherein the fingerprint calculator (104) is implemented to calculate, per block, a value for the audio signal and to perform 1-bit quantization (814), wherein a first binary value is obtained when the value of a current block is higher than a value of a previous block, and wherein a second binary value is obtained when the value of the current block is smaller than that of the previous block.

**27.** A method (904) for processing an audio signal (102), comprising:

calculating (104) one fingerprint per block of the audio signal (100, 102) for a sequence of subsequent blocks in order to obtain a sequence of reference audio signal fingerprint information, wherein predetermined block division information (106) is used for calculating the sequence of reference audio signal fingerprint information, or wherein used block division information (110) is stored in association with the audio signal, in order to ensure that test audio signal fingerprints (306) are based on the same block division as reference audio signal fingerprints,

associating (122) the reference audio signal fingerprint information with the multichannel extension data (124), wherein the multichannel extension data (124) are implemented such that an approximation of a multichannel audio signal can be determined with a block of multichannel extension data together with a block of the audio signal,

wherein the reference fingerprint information for the block of the audio signal is embedded into the block of the multichannel extension data, or inserted into an output signal (132) in association with the block of multichannel extension data; and
outputting (116) the output signal (132).

**28.** A computer program having a program code for performing the method according to claim 13 or 27 when the computer program runs on a computer.

**Revendications**

**1.** Dispositif (1000) pour synchroniser des données d'extension multicanal (132) avec un signal audio (114) présentant des informations de division en blocs, pour assurer que les empreintes digitales de signal audio de test (306) se basent sur la même division en blocs que les empreintes digitales de signal audio de référence, aux données d'extension multicanal étant associées des informations d'empreinte digitale de signal audio de référence, aux caractéristiques suivantes:

un détecteur de blocs (300) destiné à détecter les informations de division en blocs (302) dans le signal audio (114);
un calculateur d'empreintes digitales (304) destiné à calculer une empreinte digitale par bloc du signal audio pour une pluralité de blocs successifs, pour obtenir une succession d'empreintes digitales de signal audio de test, le calculateur d'empreintes digitales (304) étant réalisé pour utiliser les informations de division en blocs (302) pour calculer la succession d'empreintes digitales du signal audio de test (306);
un extracteur d'empreintes digitales (308) destiné à extraire une succession d'empreintes digitales du signal audio de référence des informations d'empreinte digitale du signal audio de référence qui sont associées aux données d'extension multicanal (132);
un corrélateur d'empreintes digitales (312) destiné à corréler la succession d'empreintes digitales du signal audio de test et la succession d'empreintes digitales du signal audio de référence; et
un compensateur (316) destiné à réduire ou à éliminer un décalage dans le temps entre les données d'extension multicanal (132) et le signal audio sur base d'un résultat de corrélation (314).

**2.** Dispositif selon la revendication 1, dans lequel le détecteur de blocs (300) est réalisé pour détecter une limite de bloc d'une division en blocs régulière, et
dans lequel le calculateur d'empreintes digitales (304) est réalisé pour diviser le signal audio partant de la limite de bloc en blocs successifs de même longueur, et pour calculer, pour chaque bloc, une empreinte digitale, pour obtenir la succession d'empreintes digitales du signal audio de test.

**3.** Dispositif selon la revendication 1 ou 2, dans lequel les données d'extension multicanal (132) ont une structure en blocs, un bloc de données d'extension multicanal étant associé à un bloc du signal audio (114), pour générer (1102), à partir du signal audio pour le bloc et des données d'extension multicanal pour le bloc, un signal audio multicanal qui se rapproche d'un signal original audio multicanal,
dans lequel à chaque bloc de données d'extension multicanal est associée une empreinte digitale de référence qui est dérivée d'un bloc du signal audio qui est dérivé d'un bloc respectif des signaux audio multicanal desquels sont dérivées les données d'extension multicanal du signal audio multicanal, ou qui a une association connue avec le bloc des signaux audio multicanal.

**4.** Dispositif selon l'une des revendications précédentes, dans lequel les informations de division en blocs (302) présentent un filigrane qui est incorporé dans le signal audio, et
dans lequel le détecteur de blocs (300) présente un extracteur de filigrane, pour détecter le filigrane dans le signal audio.

**5.** Dispositif selon la revendication 4, dans lequel le filigrane est incorporé dans un bloc du signal audio, de sorte que le filigrane se répète dans des blocs successifs du signal audio, et
dans lequel le détecteur de blocs (300) est réalisé pour effectuer une corrélation (608) entre une séquence de bruit connue (500) et le signal audio sur base d'une division en blocs de test sur plusieurs blocs, et
dans lequel le détecteur de blocs (300) présente une commande (612) qui est réalisée pour détecter une pointe de corrélation dans un résultat de la corrélation (608) qui indique un décalage de valeurs de balayage entre une division en blocs initiale et la division en blocs de test.

**6.** Dispositif selon l'une des revendications précédentes, dans lequel le calculateur d'empreinte digitale (304) est réalisé pour calculer, par bloc, une énergie du signal audio.

7. Dispositif selon l'une des revendications précédentes, dans lequel le calculateur d'empreintes digitales est réalisé pour calculer, par bloc, une différence entre une valeur d'empreinte digitale pour un bloc actuel et une valeur d'empreinte digitale pour un bloc précédent.

8. Dispositif selon la revendication 6 ou 7, dans lequel les informations d'empreinte digitale de signal audio de référence présentent une succession de valeurs d'énergie absolues du signal audio, et
dans lequel l'extracteur d'empreinte digitale (308) est réalisé pour calculer une valeur de différence entre deux valeurs d'énergie absolues successives de sorte qu'à partir de la succession de valeurs d'énergie absolues soit obtenue une succession de valeurs de différence représentant la succession d'empreintes digitales de signal audio de référence.

9. Dispositif selon l'une des revendications précédentes, dans lequel les informations d'empreinte digitale de signal audio de référence sont des valeurs codées de manière entropique, et
dans lequel l'extracteur d'empreinte digitale (308) est réalisé pour effectuer un décodage entropique.

10. Dispositif selon l'une des revendications précédentes, dans lequel l'extracteur d'empreinte digitale (308) ou le calculateur d'empreinte digitale (304) sont réalisés pour effectuer une régulation d'amplification statique ou dynamique adaptée à une courbe d'enveloppe du signal audio (808).

11. Dispositif selon l'une des revendications 1 à 5, dans lequel le calculateur d'empreinte digitale (304) est réalisé pour calculer, pour un bloc du signal audio (818), un quotient à partir d'une valeur maximale du signal audio et d'une moyenne arithmétique du signal audio dans le bloc.

12. Dispositif selon l'une des revendications précédentes, dans lequel le calculateur d'empreinte digitale (304) est réalisé pour calculer, par bloc, une valeur pour le signal audio, et pour effectuer une quantification de 1 bit (814), une première valeur binaire étant obtenue lorsque la valeur d'un bloc actuel est supérieure à une valeur d'un bloc précédent, et une deuxième valeur binaire étant obtenue lorsque la valeur du bloc actuel est inférieure à la valeur du bloc précédent.

13. Procédé (1000) pour synchroniser des données d'extension multicanal (132) avec un signal audio (114) présentant des informations de division en blocs, pour assurer que les empreintes digitales du signal audio de test (306) se basent sur la même division en blocs que les empreintes digitales du signal audio de référence, aux données d'extension multicanal étant associées des informations d'empreinte digitale de signal audio de référence, avec le fait de:

détecter (300) les informations de division en blocs (302) dans le signal audio (114);
calculer (304) une empreinte digitale par bloc du signal audio pour une pluralité de blocs successifs, pour obtenir une succession d'empreintes digitales de signal audio, les informations de division en blocs (302) étant utilisées pour calculer la succession d'empreintes digitales de signal audio de test (306);
extraire (308) une succession d'empreintes digitales de signal audio de référence des informations d'empreinte digitale de signal audio de référence qui sont associées aux données d'extension multicanal (132);
corréler (312) la succession d'empreintes digitales de signal audio de test et la succession d'empreintes digitales du signal audio de référence; et
réduire (316) ou éliminer un décalage dans le temps entre les données d'extension multicanal (132) et le signal audio sur base d'un résultat de corrélation (314).

14. Dispositif (904) pour traiter un signal audio (102), aux caractéristiques suivantes:

un calculateur d'empreinte digitale (104) destiné à calculer une empreinte digitale par bloc du signal audio (100, 102) pour une succession de blocs successifs, pour obtenir une succession d'informations d'empreinte digitale de signal audio de référence, où le calculateur d'empreinte digitale (104) est réalisé pour utiliser une information de division en blocs prédéterminée (106), pour calculer la succession d'informations d'empreinte digitale de signal audio de référence, ou pour mémoriser les informations de division en blocs (110) utilisées en association avec le signal audio, pour assurer que les empreintes digitales de signal audio de test (306) se basent sur la même division en blocs que les empreintes digitales de signal audio de référence,
un incorporateur d'informations d'empreinte digitale (122) pour associer les informations d'empreinte digitale de signal audio de référence aux données d'extension multicanal (124), les données d'extension multicanal (124) étant réalisées de sorte que par un bloc des données d'extension multicanal ensemble avec un bloc du signal audio puisse être déterminée une approximation d'un signal audio multicanal,

dans lequel l'incorporateur d'informations d'empreinte digitale (122) est réalisé pour incorporer les informations d'empreinte digitale de référence pour le bloc du signal audio dans le bloc de données d'extension multicanal, ou pour les introduire dans une association avec le bloc de données d'extension multicanal dans un signal de sortie (132); et

une interface de sortie (116) destinée à sortir le signal de sortie (132).

**15.** Dispositif selon la revendication 14, dans lequel le signal audio (100) présente les informations de division en blocs et le calculateur d'empreinte digitale (104) est réalisé pour déterminer les informations de division en blocs du signal audio (108).

**16.** Dispositif selon la revendication 14, dans lequel le signal audio (102) ne comprend pas l'information de division en blocs et le calculateur d'empreinte digitale (104) est réalisé pour fournir les informations de division en blocs (110) à un incorporateur d'information de division en blocs (112) pour qu'il incorpore les informations de division en blocs dans le signal audio, et

dans lequel l'interface de sortie (116) est réalisée pour sortir par ailleurs le signal audio (114) avec les informations de division en blocs incorporées.

**17.** Dispositif selon la revendication 16, dans lequel l'incorporateur d'informations de division en blocs (112) est réalisé pour incorporer, comme information de division en blocs, un filigrane dans le signal audio.

**18.** Dispositif selon la revendication 17, dans lequel le calculateur d'empreintes digitales (104) est réalisé pour effectuer une division en blocs du signal audio, et dans lequel l'incorporateur d'information de division en blocs (112) est réalisé pour incorporer dans ce bloc un filigrane qui est identique à un filigrane incorporé dans un bloc précédent ou suivant.

**19.** Dispositif selon la revendication 17 ou 18, dans lequel l'incorporateur d'information de division en blocs (112) est réalisé pour incorporer, comme filigrane, une séquence de pseudo-bruit prédéterminée.

**20.** Dispositif selon l'une quelconque des revendications 14 à 19, dans lequel le calculateur d'empreintes digitales est réalisé pour effectuer un calcul d'énergie (802) par bloc du signal audio.

**21.** Dispositif selon l'une des revendications 14 à 20, dans lequel le calculateur d'empreintes digitales est réalisé pour effectuer une formation de différence (806) entre une valeur d'empreinte digitale d'un bloc précédent et une valeur d'empreinte digitale d'un bloc actuel.

**22.** Dispositif selon l'une des revendications 14 à 21, dans lequel le calculateur d'empreintes digitales est réalisé pour sortir, comme informations d'empreinte digitale de signal audio de référence, des valeurs du bloc actuel et du bloc précédent sans formation de différence (808).

**23.** Dispositif selon l'une des revendications 14 à 22, dans lequel le calculateur d'empreintes digitales (104) est réalisé pour effectuer une quantification (810) et un codage entropique (812).

**24.** Dispositif selon l'une des revendications 14 à 23, dans lequel le calculateur d'empreintes digitales (104) est réalisé pour effectuer une régulation d'amplification statique ou dynamique adaptée à une courbe d'enveloppe du signal audio (808).

**25.** Dispositif selon l'une des revendications 14 à 24, dans lequel le calculateur d'empreintes digitales (104) est réalisé pour calculer (818), pour un bloc du signal audio, un quotient à partir d'une valeur maximale du signal audio et d'une moyenne arithmétique du signal audio dans le bloc.

**26.** Dispositif selon l'une des revendications 14 à 20, dans lequel le calculateur d'empreintes digitales (104) est réalisé pour calculer, par bloc, une valeur pour le signal audio, et pour effectuer une quantification de 1 bit (814), une première valeur binaire étant obtenue lorsque la valeur d'un bloc actuel est supérieure à une valeur d'un bloc précédent, et une deuxième valeur binaire étant obtenue lorsque la valeur du bloc actuel est inférieure à celle du bloc précédent.

**27.** Procédé (904) pour traiter un signal audio (102), avec le fait de:

calculer (104) une empreinte digitale par bloc du signal audio (100, 102) pour une succession de blocs successifs, pour obtenir une succession d'informations d'empreinte digitale de signal audio de référence, une information de division en blocs prédéterminée (106) étant utilisée pour calculer la succession d'informations d'empreinte digitale de signal audio de référence, ou des informations de division en blocs utilisées (110) étant mémorisées en association avec le signal audio, pour assurer que les empreintes digitales de signal audio de test (306) se basent sur la même division en blocs que les empreintes digitales de signal audio de référence,

associer (122) les informations d'empreinte digitale de signal audio de référence avec les données d'extension multicanal (124), les données d'extension multicanal (124) étant réalisées de sorte que par un bloc des données d'extension multicanal ensemble avec un bloc du signal audio puisse être déterminée une approximation d'un signal audio multicanal,

dans lequel les informations d'empreinte digitale de référence pour le bloc du signal audio sont incorporées dans le bloc des données d'extension multicanal, ou sont introduites en association avec le bloc des données d'extension multicanal dans un signal de sortie (132); et

sortir (116) le signal de sortie (132).

**28.** Programme d'ordinateur avec un code de programme pour réaliser le procédé selon la revendication 13 ou 27 lorsque le programme d'ordinateur est exécuté sur un ordinateur.

100 — Audiosignal mit Blockeinteilungsinformationen

Blockdetektor — 108

102 — 100 — Audiosignal ohne Blockeinteilungsinformationen

Blockeinteilungsinformationen

106

Fingerabdruck-
berechner

110
Blockeinteil.-
informationen

Blockeinteilungsinformationseinbetter

112

128 — Mehrkanalaudio
signal

Mehrkanal-
erweiterungsdatenberechner

126

124

Folge von
Refrenz-
Audiosignal-
FA-Informat.

104

120

Fingerabdruck-
informationseinbetter

122

114

130

118

Ausgangsschnittstelle

116

132

Ausgangssignal

**FIGUR 1**

Audiosignal
100/102

vorbestimmte Blockeinteilungsinformation

104a — Blockbildungseinrichtung

106

Blockeinteilungsinformation zur
Speicherung/
Einbettung

110

104b — Fingerabdruckwert-
berechner

104c — Fingerabdrucknachverarbeiter

120

Folge von Referenz-Audiosignal-
Fingerabdruckinformationen

## FIGUR 2

FIGUR 3A

FIGUR 3B

Audiosignal in Samples

402

Daten

Wasserzeichen

404

400

| Block i | Block i + 1 | Block i + 2 |

## FIGUR 4A

SYNC          SYNC          SYNC

| | FAI i | MKED i | | FAI i+1 | MKED i+1 | | FAI i+2 | MKED i+2 | |

960          960          960

950    124    950    124    950    124

## FIGUR 4B

Wasserzeicheneinbettung

FIGUR 5

Wasserzeichenextraktion

FIGUR 6

korrigierte Blockeinteilung = Test-Blockeinteilung - Δn

FIGUR 7

Audiosignal

800 — Blockeinteilung

818

802 — Energieberechnung pro Block

Zeit/Frequenz-Umsetzung und spektraler Crestfaktor

804 — Minimumbegrenzung und Logarithmierung

814

808

806 — Differenzbildung (ggf. nur ein Decoder)

1-Bit-Quantisierung

Diff. > 0: 1
Diff. < 0: -1

808 — Skalierung mit Verstärkungsfaktor

zum FA-Korrelator

810 — Quantisierung (z.B. auf 8 Bits)

811

812 — Entropiecodierung (nur im Encodierer)

in Datenstrom

813

FIGUR 8

900

Mehrkanalaudiosignal

Audiosignal
(Mono-Downmix oder Stereo-Downmix)

L
C
R
LS
RS

Abwärtsmischung
(Downmix)

102

Vorrichtung
zum
Verarbeiten
(FIGUR 1)

118

904

124

132

Mehrkanal-
erweiterungsdatenberechner
BCC/MPEG Surr.

Mehrkanalerweiterungsdaten

902

**FIGUR 9**

1102

rekonstruierte
Mehrkanalaudiosignale

Audiosignal (AS)
(Downmix)

Aufwärtsmischer
(Upmix)

L'
C'
R'
LS'
RS'

Mehrkanal-
erweiterungsdaten (MKED)

AS

Synchronisierer
(FIGUR 3A)

114

1000

132 MKED

**FIGUR 10**

Blockbildung 910

Zeit/Frequenz-
umsetzung
(Transf./Filterbank)

ICC/ICLD
pro Band und Block
und Kanal

L

C

R

LS

RS

BEI 106 110

BEI

912

915 914

918 916

Fingerabdruck
pro Block des
Downmix-Signals

Datenstromformatierer

130 MKED mit
Ref.-AS-FA-Infor.

## FIGUR 11A

950 Block i

| | $F_{Ai}$ | $ICCD_1$ Band 1 - Band n | $ICCD_2$ Band 1 - Band n | $ICCD_3$ Band 1 - Band n | $ICCD_4$ Band 1 - Band n | $ICCD_5$ Band 1 - Band n | $ICC_1$ Band 1 - Band n | $ICC_2$ Band 1 - Band n | $ICC_3$ Band 1 - Band n | $ICC_4$ Band 1 - Band n | $ICC_5$ Band 1 - Band n |
|---|---|---|---|---|---|---|---|---|---|---|---|

960

## FIGUR 11B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004046746 B4

**In der Beschreibung aufgeführte Nicht-Patentliteratur**

- **J. HERRE ; C. FALLER ; S. DISCH ; C. ERTEL ; J. HILPET ; A. HOELZER ; K. LINZMEIER ; C. SPENGER ; P. KROON.** Spatial Audio Coding: Next-Generation Efficient and Compatibel Coding Oberfläche Multi-Channel Audio. *117th AES Convention, San Francisco,* 2004